# EUROPEAN PATENT APPLICATION

(11) **EP 2 400 576 A2**
(43) Date of publication of application: **28.12.2011**
(21) Application number: 11170135.5
(22) Date of filing: 16.06.2011
(51) Int. Cl.: H01L 51/42, H01G 9/20, H01L 51/00

(54) **Dye-sensitized solar cell and process for production thereof**

(30) Priority: 25.06.2010 JP 2010144379; 20.01.2011 JP 2011010293
(71) Applicant: Sony Corporation, Tokyo 108-0075 (JP)
(72) Inventor: Obana, Yoshiaki, Tokyo (JP); Suzuki, Yusuke, Tokyo (JP); Murakami, Yosuke, Tokyo (JP)
(74) Representative: Lewis, Darren John

(57) **Abstract**

A photoelectric conversion element including a dye-sensitized solar cell is provided. The photoelectric conversion element may include an electrode having a titanium oxide layer containing spindle-shaped particles of titanium oxide of anatase type. A process for manufacturing the photoelectric conversion device is also provided. The process may include steps of providing a transparent conductive layer, forming a titanium oxide layer containing particles of peroxo-modified titanium oxide of anatase type adjacent to the transparent conductive layer, and baking the titanium oxide layer. Forming the titanium oxide layer may include forming a porous titanium oxide layer and dipping the porous titanium oxide layer in a dispersion containing particles of peroxo-modified titanium oxide of anatase type to the porous titanium oxide layer. Alternatively, forming the titanium oxide layer may include applying a titanium oxide paste containing particles of peroxo-modified titanium oxide of anatase type to the transparent conductive layer.

## Description

The present disclosure relates to a dye-sensitized solar cell and a process for production thereof, the solar cell has a low internal resistance and a high photoelectric conversion efficiency.

A dye-sensitized solar cell is composed of a semiconductor electrode containing a dye adsorbed thereto, a counter electrode opposed to the semiconductor electrode, and an electrolyte held between these electrodes. It is so designed as to generate electricity by conversion of light energy into electric energy upon absorption of light by the dye. It is expected to find practical use because of its low material cost and high safety.

The dye-sensitized solar cell has a semiconductor electrode which is usually composed of a transparent substrate, a semiconductor layer formed thereon by coating with semiconductor fine particles, and a spectral sensitizing dye adsorbed thereto that has an absorption band in the visible region.

Various respective aspects and features of the invention are defined in the appended claims. Combinations of features from the dependent claims may be combined with features of the independent claims as appropriate and not merely as explicitly set out in the claims.

Embodiments presented herein are suitable for addressing problems that have arisen in prior dye-sensitized solar cells. A dye-sensitized solar cell and a process for production thereof is described herein, where the dye-sensitized solar cell has a low internal resistance and a high photoelectric conversion efficiency.

In a first embodiment, a process for producing a dye-sensitized solar cell is provided, the process including a step of coating a transparent conductive layer with a layer of titanium oxide containing titanium oxide particles of peroxo-modified anatase type and a step of baking the titanium oxide layer.

The process according to the first embodiment described may include a step of baking the titanium oxide layer containing titanium oxide particles of peroxo-modified anatase type. This baking step may result in good binding of the particles of titanium oxide of peroxo-modified anatase type to their adjacent particles of titanium oxide of anatase type. The thus bonded particles of titanium oxide constitute a good conduction pass.

In a second embodiment, a dye-sensitized solar cell is provided which has a transparent conductive layer, a layer of titanium oxide which is formed on the transparent conductive layer and which supports a sensitizing dye, a counter electrode arranged opposite to the layer of titanium oxide, and a layer of electrolyte arranged between the layer of titanium oxide and the counter electrode, with the layer of titanium oxide containing particles of titanium oxide of anatase type and the particles of titanium oxide of anatase type bond to their adjacent particles of titanium oxide of anatase type in such a way that the bonded particles have a matched crystal lattice in their interface.

The dye-sensitized solar cell according to the second embodiment described above is such that the adjacent particles of titanium oxide bond to each other in such a way that the bonded particles have a matched crystal lattice in their interface. The thus bonded particles of titanium oxide constitute a good conduction pass.

In an illustrative embodiment, a photoelectric conversion element is provided. The photoelectric conversion element includes an electrode including a titanium oxide layer containing spindle-shaped particles of titanium oxide of anatase type.

In another illustrative embodiment, a method of manufacturing a photoelectric conversion element is provided. The method includes providing a transparent conductive layer; and forming a titanium oxide layer containing particles of peroxo-modified titanium oxide of anatase type adjacent to the transparent conductive layer.

The embodiments summarized above provide for a dye-sensitized solar cell having a low internal resistance and a high photoelectric conversion efficiency. Other aspects, embodiments, advantages and features of the disclosure will become apparent from the following detailed description.

Non-limiting embodiments of the present disclosure will be described by way of example with reference to the accompanying figures, which are schematic and are not intended to be drawn to scale. In the figures, each identical or nearly identical component illustrated is typically represented by a single numeral. For purposes of clarity, not every component is labeled in every figure, nor is every component of each embodiment of the disclosure shown where illustration is not necessary to allow those of ordinary skill in the art to understand the disclosure. In the figures:
Fig. 1A is a diagram illustrating the process for producing the dye-sensitized solar cell pertaining to the first embodiment of the present disclosure, and Fig. 1B is a diagram illustrating the structure of the dye-sensitized solar cell pertaining to an embodiment described herein;
Fig. 2 is a diagram illustrating the structure of the porous layer of titanium dioxide of the dye-sensitized solar cell pertaining to an embodiment described herein;
Fig. 3 is a diagram illustrating the process for producing the dye-sensitized solar cell pertaining to an embodiment described herein;
Fig. 4 is a diagram illustrating an FT-IR spectrum of the titanium oxide of peroxo-modified anatase type pertaining to an embodiment described herein;
Fig. 5 is a diagram illustrating an X-ray diffraction (XRD) pattern of the titanium oxide of peroxo-modified anatase type pertaining to an embodiment described herein;
Figs. 6A and 6B are micrographs of the titanium oxide of peroxo-modified anatase type pertaining to an embodiment described herein which were taken by a transmission electron microscope (TEM);
Fig. 7 is a diagram illustrating relations between the parameters used in the step of forming the porous layer of titanium dioxide and the characteristic properties of the dye-sensitized solar cell pertaining to an embodiment described herein;
Figs. 8A and 8B are diagrams illustrating relations between the parameters used in the step of forming the porous layer of titanium dioxide and the characteristic properties of the dye-sensitized solar cell pertaining to an embodiment described herein;
Fig. 9 is a diagram illustrating relations between the parameters used in the step of forming the porous layer of titanium dioxide and the characteristic properties of the dye-sensitized solar cell pertaining to an embodiment described herein;
Fig. 10 is a diagram illustrating the spectral sensitivity characteristics (IPCE) of the dye-sensitized solar cell pertaining to an embodiment described herein;
Figs. 11A and 11B are TEM micrographs of the yellow powder in Example 22, and Fig. 11C is a diagram illustrating an X-ray diffraction (XRD) pattern of the yellow powder in Example 22;
Fig. 12A is a TEM micrograph of the yellow powder in Example 26, and Fig. 12B is a diagram illustrating an X-ray diffraction (XRD) pattern of the yellow powder in Example 26;
Fig. 13A is a TEM micrograph of the yellow powder in Example 28, and Fig. 13B is a diagram illustrating an X-ray diffraction (XRD) pattern of the yellow powder in Example 28;
Fig. 14 is a diagram illustrating the results of evaluation of the characteristic properties of the dye-sensitized solar cell pertaining to Examples 22 to 32;
Fig. 15A is a TEM micrograph of the entire sample electrode pertaining to Example 33, and Fig. 15B is a TEM micrograph of the TiO₂ layer in the electrode;
Figs. 16A and 16B are enlarged TEM micrographs showing the encircled part in Fig. 15B;
Fig. 17A is an enlarged TEM micrograph showing a portion of Figs. 16A and 16B, and Figs. 17B and 17C are diagrams showing the region for enlargement in Fig. 17A;
Fig. 18A is an enlarged TEM micrograph showing a portion of Figs. 16A and 16B, and Figs. 18B and 18C are diagrams showing the region for enlargement in Fig. 18A;
Figs. 19A and 19B are TEM micrographs showing other parts than those shown in Figs. 16A and 16B;
Fig. 20A is an enlarged TEM micrograph showing a portion of Figs. 19A and 19B, and Figs. 20B and 20C are diagrams showing the region for enlargement in Fig. 20A;
Fig. 21A is an enlarged TEM micrograph showing a portion of Figs. 19A and 19B, and Figs. 21B and 21C are diagrams showing the region for enlargement in Fig. 21A;
Figs. 22A and 22B are partly enlarged TEM micrographs of the TiO₂ layer in Example 34;
Fig. 23A is an enlarged TEM micrograph showing a portion of Figs. 22A and 22B, and Figs. 23B and 23C are diagrams showing the region for enlargement in Fig. 23A; and
Fig. 24 is a diagram illustrating an existing process for forming a porous layer of titanium dioxide.

Existing solar cells demand that electrons migrate rapidly from the layer of spectral sensitizing dye (such as ruthenium complex), which has become excited upon absorption of light, into the layer of titanium oxide semiconductor. If it were not for rapid electron migration, the ruthenium complex undergoes recombination with electrons or electrons flow backward resulting in dark current or back current. This leads to a reduced conversion efficiency.

One possible way to address this problem is to increase the amount of the sensitizing dye adsorbed into the titanium oxide semiconductor layer or to improve the mobility of electrons in the titanium oxide semiconductor layer.

In some embodiments, a practical method would be to coat the transparent electrode repeatedly with titania sol (with each coating step followed by drying and baking) so that the resulting titanium oxide layer becomes porous and hence supports Ru complex in a larger amount on its surface. Another method may be to perform the baking of titania particles at temperatures higher than 400°C so as to improve their conductivity.

Although baking at temperatures above 400°C may be expected to increase the power generating characteristics, in some cases, such baking may be disadvantageous in giving rise to a titanium oxide layer in which individual titanium oxide particles are separated by interstices of one kind or the other. Interstices of the first kind may occur between the titanium oxide layer (which has been formed on the conductive substrate) and the transparent electrode. They cause the electrolyte and the transparent electrode to come into direct contact with each other, which may lead to leakage current and decrease the photoelectric conversion efficiency. Interstices of the second kind occur among individual titanium oxide particles existing in the titanium oxide layer. They reduce the conducting pass that reaches the conductive substrate through the titanium oxide layer. This reduces the ratio of excited electrons (generated in the titanium oxide layer) reaching the transparent electrode, which in turn reduces the photoelectric conversion efficiency.

In some existing solar cells, a diffusion barrier is formed between the porous titanium oxide layer and the transparent conductive layer. This barrier layer may have the disadvantage of demanding special equipment with high corrosion resistance and high safety, which increases cost for mass production, because it needs a halogenated titanium compound (such as TiCl₄) in the step of its formation. TiCl₄ contains highly corrosive chlorine and gives off fumes of hydrochloric acid upon reaction with moisture in the air. Similar problems also arise when the porous titanium oxide layer formed by coating (followed by baking) with titanium oxide paste is dipped in an aqueous solution of TiCl₄, which is followed by baking.

Present embodiments described are able to address the issues raised by the foregoing. It is desirable to provide a dye-sensitized solar cell and a process for production thereof, the dye-sensitized solar cell having a low internal resistance and a high photoelectric conversion efficiency.

In a first embodiment, a process for producing a dye-sensitized solar cell is provided, the process including a step of coating a transparent conductive layer with a layer of titanium oxide containing titanium oxide particles of peroxo-modified anatase type and a step of baking the titanium oxide layer.

The process according to the first embodiment includes a step of baking the titanium oxide layer containing titanium oxide particles of peroxo-modified anatase type. This baking step results in good binding of the particles of titanium oxide of peroxo-modified anatase type to their adjacent particles of titanium oxide of anatase type. The thus bonded particles of titanium oxide constitute a good conduction pass.

In a second embodiment described herein, a dye-sensitized solar cell which has a transparent conductive layer is provided, a layer of titanium oxide which is formed on the transparent conductive layer and which supports a sensitizing dye, a counter electrode arranged opposite to the layer of titanium oxide, and a layer of electrolyte arranged between the layer of titanium oxide and the counter electrode, with the layer of titanium oxide containing particles of titanium oxide of anatase type and the particles of titanium oxide of anatase type bond to their adjacent particles of titanium oxide of anatase type in such a way that the bonded particles have a matched crystal lattice in their interface.

The dye-sensitized solar cell according to the second embodiment may be such that the adjacent particles of titanium oxide bond to each other in such a way that the bonded particles have a matched crystal lattice in their interface. The thus bonded particles of titanium oxide constitute a good conduction pass.

Embodiments presented herein provide for a dye-sensitized solar cell having a low internal resistance and a high photoelectric conversion efficiency.

According to embodiments presented herein, the process for production of the dye-sensitized solar cell is such that the layer of titanium oxide additionally contains spherical particles of titanium oxide of anatase type and the step of baking is carried out so that the particles of titanium oxide of peroxo-modified anatase type bond to the particles of titanium oxide of anatase type in such a way that the bonded particles have a matched crystal lattice in their interface. This process permits the titanium oxide particles constituting the layer of titanium oxide to form good conduction pass and hence provides the dye-sensitized solar cell having a low internal resistance and a high photoelectric conversion efficiency. The process according to the present embodiment may include a step of coating a transparent conductive layer with a layer of titanium oxide and a subsequent step of treating the layer of titanium oxide with a dispersion containing particles of titanium oxide of peroxo-modified anatase type. This process employs a dispersion, which is noncorrosive unlike titanium tetrachloride and is free from organic solvent, and hence it is favorable to environmental protection and reduced production cost. Thus, this process provides the dye-sensitized solar cell having a low internal resistance and a high photoelectric conversion efficiency.

The process according to the present embodiment may employ the particles of titanium oxide of peroxo-modified anatase type which contain spindle-shaped particles of peroxo-modified anatase type. The two kinds of particles of titanium oxide mixed together result in an increased bonding area of particles of titanium oxide. Thus, this process provides the dye-sensitized solar cell having a low internal resistance and a high photoelectric conversion efficiency.

The process according to the present embodiment may include a step of coating a transparent conductive layer by spreading or printing with a paste of titanium oxide containing particles of titanium oxide of peroxo-modified anatase type, so that a layer of titanium oxide is formed. This coating step is followed by baking which permits the particles of titanium oxide of peroxo-modified anatase type to release the peroxo groups from them. As the result, the particles of titanium oxide of peroxo-modified anatase type change into the particles of titanium oxide of anatase type and adjacent particles of titanium dioxide of anatase type bond together. Thus, this process provides the dye-sensitized solar cell having a low internal resistance and a high photoelectric conversion efficiency.

The process according to the present embodiment may employ a paste of titanium oxide which contains spherical particles of titanium oxide of anatase type and spindle-shaped particles of titanium oxide of peroxo-modified anatase type. The two kinds of particles of titanium oxide bond together to give an increased bonding area of particles of titanium oxide. Thus, this process provides the dye-sensitized solar cell having a low internal resistance and a high photoelectric conversion efficiency.

The process according to the present embodiment may employ a dispersion at a temperature no lower than 50°C and no higher than 100°C. Thus, this process provides the dye-sensitized solar cell having a low internal resistance and a high photoelectric conversion efficiency.

The process according to the present embodiment may employ a dispersion which contains particles having an average particle diameter no smaller than 3 nm and no larger than 100 nm. Thus, this process provides the dye-sensitized solar cell having a low internal resistance and a high photoelectric conversion efficiency.

The process according to the present embodiment may employ a dispersion which contains particles having an average particle diameter no smaller than 5 nm and no larger than 60 nm. Thus, this process provides the dye-sensitized solar cell having a low internal resistance and a high photoelectric conversion efficiency.

The process according to the present embodiment may employ a dispersion which contains solids in an amount no less than 0.1 wt% and no more than 3.0 wt%. Thus, this process provides the dye-sensitized solar cell having a low internal resistance and a high photoelectric conversion efficiency. If the dispersion contains solids in an amount less than 0.1 wt%, it would be necessary for the layer of titanium oxide to be dipped in the dispersion repeatedly to ensure good bonding between the particles of titanium dioxide in the layer of titanium oxide. This is inefficient and impractical. By contrast, the dispersion will be poor in storage stability if it contains solids more than 3.0 wt%. Moreover, it will deposit excess solids on the layer of titanium oxide, thereby reducing the specific surface area of the layer of titanium oxide and decreasing the amount of the adsorbed dye. This leads to a low photoelectric conversion efficiency.

The more preferred process according to the present embodiment may employ a dispersion which contains solids in an amount no less than 0.5 wt% and no more than 2.5 wt%. The dispersion containing solids in such amounts has good storage stability and contributes to high production efficiency, without the layer of titanium oxide decreasing in specific surface area and the amount of adsorbed dye decreasing. Thus, this process provides the dye-sensitized solar cell having a low internal resistance and a high photoelectric conversion efficiency.

The process according to the present embodiment may have an additional step of irradiating the layer of titanium oxide with ultraviolet light and/or plasma prior to the step of forming the layer of titanium oxide. This additional step removes contaminants (such as organic matter) adhering to the layer of titanium oxide, thereby promoting reactions between the particles of titanium oxide of peroxo-modified anatase type and the layer of titanium oxide. Thus, this process provides the dye-sensitized solar cell having a low internal resistance and a high photoelectric conversion efficiency.

The process according to the present embodiment may have an additional step of allowing the layer of titanium oxide to support a dye that follows the step of baking. This additional step increases the amount of the dye to be supported on the layer of titanium oxide. Thus, this process provides the dye-sensitized solar cell having a low internal resistance and a high photoelectric conversion efficiency.

The process according to the present embodiment may have an additional step for filling the gap between the counter electrode and the transparent conductive layer with an electrolyte that follows the step of allowing the layer of titanium oxide to support a dye. Thus, this process provides the dye-sensitized solar cell having a low internal resistance and a high photoelectric conversion efficiency.

The process according to the present embodiment may have an additional step of treating (followed by drying) the transparent conductive layer with an aqueous solution of titanium tetrachloride and/or a dispersion containing particles of titanium oxide of peroxo-modified anatase type, the additional process preceding the step of forming the layer of titanium oxide. This additional step increases the conductivity between the transparent conductive layer and the layer of titanium oxide. Thus, this process provides the dye-sensitized solar cell having a low internal resistance and a high photoelectric conversion efficiency.

According to the process of the present embodiment, a transparent conductive layer is coated with a layer of titanium oxide, which subsequently undergoes baking. This baking step should preferably be carried out in air or oxygen at a temperature no lower than 250°C and no higher than 700°C. Baking in this manner promotes crystallization of the titanium dioxide of anatase type. Thus, this process provides the dye-sensitized solar cell having a low internal resistance and a high photoelectric conversion efficiency. Incidentally, baking at a temperature lower than 250°C does not crystallize the particles of titanium oxide of peroxo-modified anatase type into titanium dioxide of anatase type. By contrast, baking at a temperature higher than 700°C turns the particles of titanium oxide of peroxo-modified anatase type into titanium oxide of rutile type. This leads to a low photoelectric conversion efficiency. For the dye-sensitized solar cell to have a low internal resistance and a high photoelectric conversion efficiency, the layer of titanium oxide should preferably undergo baking at a temperature no lower than 350°C and no higher than 600°C for no shorter than 10 minutes and no longer than 360 minutes.

The process according to the present embodiment should preferably employ the particles of titanium oxide of anatase type which contain spherical particles of titanium oxide of anatase type and spindle-shaped particles of titanium oxide of anatase type. The spherical particles bond with their adjoining spindle-shaped particles in such a way that a matched crystal lattice occurs in the interface between the bonded particles. Bonding in this manner forms a good conduction pass between the spherical particles and their adjoining spindle-shaped particles. Thus, this process provides the dye-sensitized solar cell having a low internal resistance and a high photoelectric conversion efficiency.

The process according to the present embodiment should proceed in such a way that particles of titanium oxide of anatase type bond together to form a single crystal (in which particles of titanium oxide of anatase type orient in one direction and have a matched crystal lattice in their interface). Bonding in this manner forms a good conduction pass owing to the unidirectional orientation and the single crystal. Thus, this process provides the dye-sensitized solar cell having a low internal resistance and a high photoelectric conversion efficiency.

The process according to the present embodiment should proceed in such a way that adjacent particles of titanium oxide of anatase type bond together along a plane. Bonding in this manner permits adjoining particles of titanium oxide to form a good conduction pass. Thus, this process provides the dye-sensitized solar cell having a low internal resistance and a high photoelectric conversion efficiency.

Incidentally, the dye-sensitized solar cell has the internal resistance in the form of both parallel resistance and serial resistance. In the foregoing (and the following) description, the internal resistance denotes that in the form of serial resistance. The internal resistance includes the resistance of the counter electrode (which is formed from platinum), the resistance of the transparent conductive layer which functions as the working electrode (which is formed from FTO), the resistance due to contact between the porous metal oxide semiconductor layer and the transparent conductive layer, and the redox diffusion resistance.

The embodiments of the present disclosure will be described in more detail with reference to the accompanying drawings. They are not intended to restrict the scope of the present disclosure so long as they produce the effect of the present disclosure. The drawings in each embodiment are given the same symbols for the identical or corresponding parts.
1. The first embodiment (in which the porous titanium dioxide layer is treated with a dispersion containing particles of titanium oxide of peroxo-modified anatase type)
2. The second embodiment (in which the porous titanium dioxide layer is formed from a paste of titanium oxide containing particles of titanium oxide of peroxo-modified anatase type)

### [The first embodiment]

In order to address problems involved in the existing technologies, the present inventors carried out a series of researches which led to a finding that there is obtained a dye-sensitized solar cell having an improved photoelectric conversion efficiency if the transparent conductive layer is coated directly with peroxotitanic acid (followed by drying), so that a titanium dioxide layer is formed on the transparent conductive layer, and subsequently the titanium dioxide layer is dipped in a dispersion containing particles of titanium oxide of peroxo-modified anatase type (which will be referred to as a dispersion of titanium oxide of peroxo-modified anatase type).

It is conjectured that the dipping of the titanium dioxide layer in a dispersion of titanium oxide of peroxo-modified anatase type does not strengthen bonding at the interface or in the vicinity of the interface between the transparent conductive layer and the titanium dioxide layer but it promotes bonding between the particles of titanium dioxide in the titanium dioxide layer which are away from the transparent conductive layer.

The treatment with a dispersion of titanium oxide of peroxo-modified anatase type is highly effective if the titanium oxide has a particle diameter within a certain range. The resulting dye-sensitized solar cell has a remarkably improved power generating efficiency and outperforms the existing one which is obtained by treatment with an aqueous solution of TiCl_{4.}

According to the first embodiment of the present disclosure, the process for production of the dye-sensitized solar cell includes the steps of coating the transparent conductive layer (which has been formed on a substrate) with a layer of titanium dioxide and dipping the layer of titanium dioxide in a dispersion of titanium oxide of peroxo-modified anatase type having a particle diameter no smaller than 3 nm and no larger than 50 nm, followed by baking.

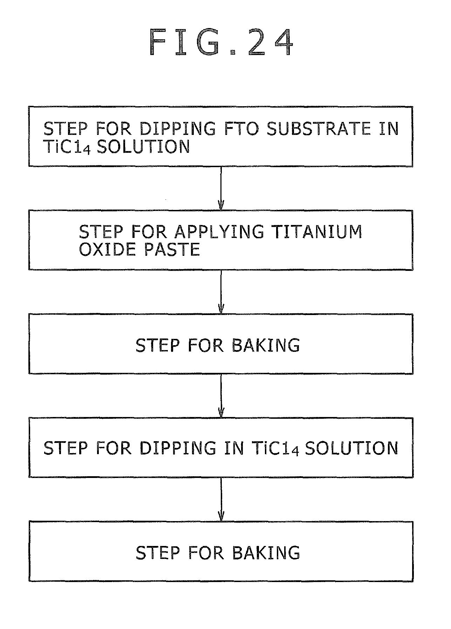

Fig. 24 shows a process for forming the porous titanium dioxide layer for dye adsorption. The process shown in Fig. 24 starts with coating a transparent conductive film (such as FTO substrate) with an aqueous solution of TiCl₄, which subsequently undergoes drying and baking. This step is followed by coating again with a paste of titanium dioxide, which is subsequently undergoes drying and baking. These two steps form a porous titanium dioxide layer on the substrate. The resulting laminate film is dipped in an aqueous solution of TiCl₄, followed by drying and baking.

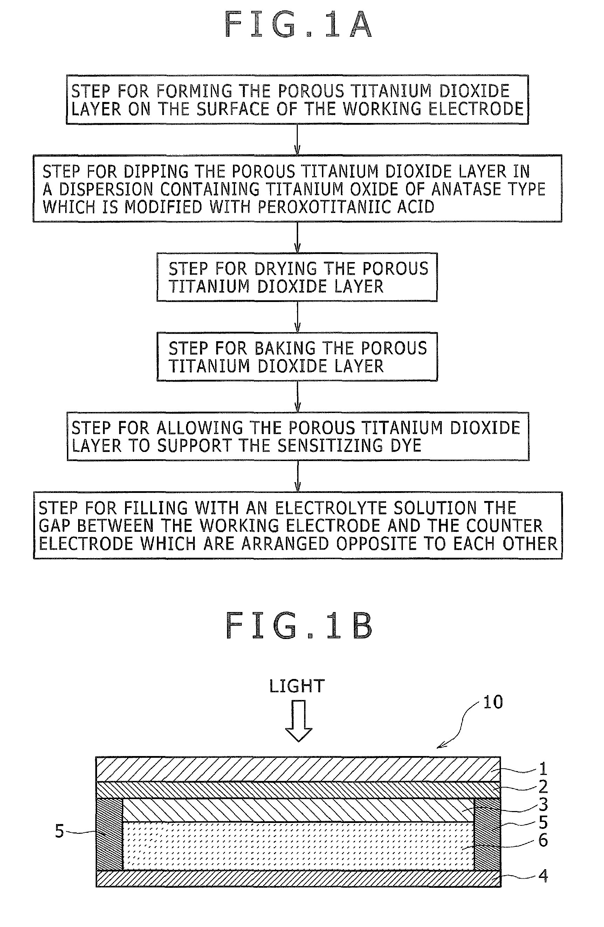

Figs. 1A and 1B are diagrams illustrating respectively the manufacturing process and the structure of the dye-sensitized solar cell pertaining to the first embodiment of the present disclosure.

As shown in Fig. 1B, the dye-sensitized solar cell is composed of the transparent substrate 1, the transparent conductive layer (working electrode or photoelectrode) 2 formed thereon, the porous titanium dioxide layer (TiO₂) 3 formed thereon, which functions as a porous metal oxide semiconductor layer, the counter electrode 4, and the electrolyte layer 6 filing the gap between the two electrodes 2 and 4 which is sealed by the sealing material 5.

As shown in Fig. 1A, the process for producing the dye-sensitized solar cell includes a first step of coating the working electrode with the porous titanium dioxide layer, a second step of dipping the porous titanium dioxide layer in a dispersion of titanium oxide of peroxo-modified anatase type which is kept at no lower than 50°C and no higher than 100°C, a third step of drying and baking the porous titanium dioxide layer, a fourth step of allowing the porous titanium dioxide layer to support a sensitizing dye, and a fifth step of filling the gap between the working electrode and the counter electrode with the electrolyte layer.

The dispersion of titanium oxide of peroxo-modified anatase type contains particles having an average particle diameter no smaller than 3 nm and no larger than 100 nm, preferably no smaller than 5 nm and no larger than 60 nm. Particles having an average diameter smaller than 3 nm will densely fill the pores in the porous titanium dioxide layer, which prevents the adsorption of the dye and the infiltration of the electrolyte to be carried out in the subsequent steps. The resulting product will not produce the effect demanded of the solar cell. By contrast, particles having an average diameter larger than 100 nm will not infiltrate into the pores of the porous titanium dioxide layer, which deteriorates the conducting characteristics. The resulting product will not produce the effect demanded of the solar cell. The dispersion of titanium oxide of peroxo-modified anatase type should contain solids in an amount no less than 0.1 wt% and no more than 3.0 wt%, preferably no less than 0.5 wt% and no more than 2.5 wt%. The content of solids less than 0.1 wt% means that there is no sufficient titanium oxide of peroxo-modified anatase type to be fixed onto the surface of the porous titanium dioxide layer. The resulting product will not produce the effect demanded of the solar cell. By contrast, the content of solids more than 3.0 wt% means that there is an excess amount of titanium oxide of peroxo-modified anatase type which clog the pores in the porous titanium dioxide layer. Clogged pores prevent the adsorption of the dye and the infiltration of the electrolyte to be carried out in the subsequent steps. The resulting product will not produce the effect demanded of the solar cell.

The following is a detailed description of the process for producing the dye-sensitized solar cell.

### [The first step: to coat the working electrode with the porous titanium dioxide layer]

The first step is to coat the transparent conductive layer (which has been formed on the surface of the transparent substrate) with the porous titanium dioxide layer.

### (Transparent substrate)

The transparent substrate 1 may be any substrate including those of glass and organic polymer such as PET, which is transparent and insulative.

### (Transparent conductive layer)

The transparent substrate 1 is coated with the transparent conductive layer 2, which may be any known transparent electrode formed from any one of tin oxide, antimony, F- or P-doped tin oxide, Sn- and/or F-doped indium oxide, antimony oxide, zinc oxide, and noble metal. The transparent electrode may be formed by any known process such as thermal decomposition and CVD.

The transparent substrate 1 and the transparent conductive layer 2 should have a high visible light transmittance, higher than 50%, preferably higher than 90%. If they have a transmittance lower than 50%, the resulting solar cell will have a low photoelectric conversion efficiency.

The transparent conductive layer 2 should preferably have a resistance lower than 100 Ω/cm². If it has a resistance higher than specified above, the resulting solar cell will be poor in photoelectric conversion efficiency.

### (Porous titanium dioxide layer)

The transparent conductive layer 2 is coated with a paste of titanium oxide prepared by dispersing titanium dioxide particles into a solvent. Upon drying (for solvent removal), there is obtained the porous titanium dioxide layer 3. The paste of titanium oxide may a commercially available one.

The paste of titanium oxide paste may contain titanium dioxide particles having an average particle diameter no smaller than 5 nm and no larger than 250 nm, particularly no smaller than 5 nm and no larger than 100 nm, and preferably no smaller than 5 nm and no larger than 50 nm. The titanium dioxide particles may be uniform in particle diameter or may be composed of particles having two different particle diameters. Titanium dioxide particles having an average particle diameter smaller than 5 nm give rise to an excessively compact film which prevents infiltration of the electrolyte solution, and this leads to a large resistance and a poor power generating efficiency. Titanium dioxide particles having an average particle diameter larger than 250 nm have a small surface area and hence adsorb a less amount of dye. Thus the resulting solar cell is poor in power generating efficiency.

### (Leakage current suppressing layer)

Prior to coating with the titanium oxide paste, the transparent conductive layer 2 may optionally be treated with an aqueous solution containing Ti in the form of TiCl₄, with a dispersion of peroxotitanic acid, or with a dispersion containing titanium oxide of peroxo-modified anatase type. This treatment gives rise to a leakage current suppressing layer.

### (Step for drying and baking)

The coating of the transparent conductive layer 2 with the titanium oxide paste is followed by drying in the atmospheric air at 50°C to 150°C for 15 to 60 minutes. Drying may be carried out by any method under any conditions without specific restrictions.

Drying may optionally be followed by baking in the atmospheric air or oxygen at 250°C to 700°C (preferably 350°C to 600°C) for 10 to 360 minutes. Baking at a temperature lower than 250°C does not form crystals of titanium dioxide of anatase type, and hence the resulting leakage current suppression layer is not sufficiently compact. By contrast, baking at a temperature higher than 700°C changes the crystal type from anatase to rutile or causes agglomeration, thereby decreasing the specific surface area of crystals.

### [The second step: for dipping in a dispersion of titanium oxide of peroxo-modified anatase type]

The second step is to dip the porous titanium dioxide layer 3 in a dispersion of titanium oxide of peroxo-modified anatase type which has an average particle diameter of 3 nm to 50 nm, or to coat the porous titanium dioxide layer 3 with the dispersion. During dipping or coating, the dispersion of titanium oxide of peroxo-modified anatase type should preferably be kept at 50°C to 100°C. Dipping or coating at a temperature lower than 50°C prevents the titanium oxide of peroxo-modified anatase type from effectively adhering to the surface of the porous titanium dioxide layer, which leads to an incomplete necking effect. Thus the resulting solar cell is poor in performance. By contrast, baking or coating at a temperature higher than 100°C causes the titanium oxide of peroxo-modified anatase type to undergo secondary agglomeration, which gives rise to extremely large particles incapable of infiltrating into pores of the porous titanium dioxide layer. The resulting solar cell is poor in performance.

The dispersion of titanium oxide of peroxo-modified anatase type is composed of a solvent and particles of titanium oxide of peroxo-modified anatase type. The latter should preferably be either spherical particles of titanium oxide of peroxo-modified anatase type or spindle-shaped particles of titanium oxide of peroxo-modified anatase type. The latter is preferable from the standpoint of improvement in photoelectric conversion efficiency.

The solvent may be water or any organic solvent selected from methanol, ethanol, isopropyl alcohol, dichloromethane, acetone, acetonitrile, and ethyl acetate. These solvents may be used alone or in combination with one another.

### (Titanium oxide of peroxo-modified anatase)

A dispersion of peroxotitanic acid is considered to contain a binuclear complex (represented by the basic structure shown below) in the form of its anion (Ti₂O₅(OH)ₓ^{(2-x)-} (x > 2) ) or polyanion (Ti_{2O5})_{q}(OH)_{y}^{(y-2q)-} (2 < q/y), with the binuclear complex having the Ti-O-O-Ti linkage which results from partial transformation of Ti-O-Ti linkage.

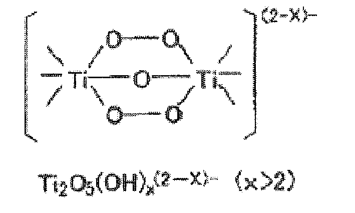

The dispersion of peroxotitanic acid may be produced by any known method which includes the following steps. First, an aqueous solution of TiCl₄ in a low concentration (0.1 mol/dm³) is given excess H₂O₂ (30 wt%). The resulting solution is mixed with NH₄OH in a ratio of 1:9 by weight. With its pH adjusted to 10, the mixture causes peroxo hydrate to precipitate. The peroxo hydrate is separated and washed with distilled water and then freed of impurities (NH₄⁺ and Cl⁻) by means of ion exchange resin. The purified peroxo hydrate is mixed and reacted with excess H₂O₂ (30 wt%) at 7°C. In this way there is obtained a dispersion of peroxotitanic acid (0.1 mol/dm³).

A dispersion of peroxotitanic acid may be commercially available from M K Techno Co., Ltd. under the trade name of PTA85.

Upon heating, peroxotitanic acid undergoes condensation to form polymerized amorphous titanium oxide or minute nuclei having regular linkages (-O-Ti-O-Ti-O-). These minute nuclei are the precursors of crystals of anatase type which grow into anatase crystals.

The dispersion of titanium oxide of peroxo-modified anatase type can be obtained by heating a dispersion of peroxotitanic acid at 65°C to 100°C for two to 40 hours. The thus obtained aqueous solution (in the form of dispersion or aqueous sol) contains titanium dioxide of anatase type which originates from the precursor of anatase crystals.

The dispersion of titanium oxide of peroxo-modified anatase type is a dispersion of peroxotitanic acid which contains crystals of titanium dioxide of anatase type having repeating units of -Ti-O-Ti-O-, the crystals being partly modified into -Ti-O-OH and the titanium dioxide having its surface modified with peroxo groups. The crystals of titanium dioxide of anatase type are flat, spindle-shaped, or sagittate.

The heating temperature mentioned above should be higher than 80°C, preferably higher than 90°C, but should be lower than 95°C. The heating time should be longer than four hours and shorter than 24 hours. Heating under 65°C does not rapidly crystallize peroxotitanic acid partly or entirely into titanium dioxide of anatase type. By contrast, heating above 100°C causes side reactions or excessive water evaporation. Heating shorter than two hours does not completely crystallize the peroxotitanic acid partly or entirely into titanium dioxide of anatase type. By contrast, heating longer than 40 hours causes too much water to evaporate.

Heating may be carried out under normal pressure or in a pressure vessel (such as autoclave) for hydrothermal processing that permits heating above 100°C without water boiling. Hydrothermal processing usually yields crystals having high crystallinity. Upon hydrothermal processing, the dispersion of peroxotitanic acid changes into the dispersion of titanium oxide of peroxo-modified anatase type which has a larger particle diameter.

The dispersion of titanium oxide of peroxo-modified anatase type may contain peroxotitanic acid and titania sol in the form of amorphous titania whose surface is covered and modified with peroxo groups.

Incidentally, the dispersion (aqueous sol) of titanium oxide of peroxo-modified anatase type is commercially available from M K Techno Co., Ltd. under a tradename of TPX85.

### (Pretreatment for porous titanium dioxide layer)

The porous titanium dioxide layer 3 may optionally undergo pretreatment before dipping in a dispersion of titanium oxide of peroxo-modified anatase type. This pretreatment is intended to clean the porous titanium dioxide layer 3 of organic contaminants and water, thereby improving its wettability or hydrophilicity. Improved wettability promotes reaction between the surface of the titanium oxide in the porous titanium dioxide layer 3 and the particles of titanium oxide of peroxo-modified anatase type.

This pretreatment should preferably be carried out in dry process, such as irradiation with rays from an excimer lamp (172 nm) or an extra-high pressure mercury lamp (including j line 313 nm, i line 365 nm, h line 405 nm, and g line 436 nm) . Another method employs UV ozone or plasma. UV ozone is generated by irradiating oxygen with ultraviolet rays (184.9 nm and/or 253.7 nm) and then decomposing the thus generated ozone by irradiation with ultraviolet rays (253.7 nm) to generate atomic oxygen radicals. Plasma is obtained by using an atmospheric or vacuum plasma equipment.

Pretreatment in the foregoing manner cleans the surface of the porous titanium dioxide layer 3 of contaminants through decomposition by radicals induced from atmospheric gas (such as oxygen, nitrogen, and argon) upon irradiation with ultraviolet rays or by radicals generated by plasma.

### (Dipping of the porous titanium dioxide layer in the dispersion of titanium oxide of peroxo-modified anatase type)

The porous titanium dioxide layer 3 should have as many pores as possible and a large specific surface area. It should also contain titanium dioxide particles capable of adsorbing a large number of dye molecules, and it should have good conductivity and also have pores that permit infiltration of the electrolyte solution. The porous titanium dioxide layer 3 has good conductivity when the particles of titanium dioxide bond with one another through necking structure (in which particles bond with one another through surface-to-surface contact in place of point-to-point contact). The term "necking treatment" used below denotes the treatment to form the surface contact structure.

The porous titanium dioxide layer 3 is usually formed by coating the transparent conductive layer with a paste of fine particles of TiO₂ dispersed in a solvent, the coating followed by drying for solvent evaporation. Titanium dioxide particles formed in this manner are not in a state that forms a good conduction pass.

For the porous titanium dioxide layer 3 to have a good conduction pass, it should undergo necking treatment in the following manner. Necking treatment involves dipping the porous titanium dioxide layer 3 in a dispersion of titanium oxide of peroxo-modified anatase type, followed by drying and baking.

The necking treatment employs a dispersion of titanium oxide of peroxo-modified anatase type (described below) so that it does not excessively reduce the number of pores originally possessed by the porous titanium dioxide layer 3 and it does not excessively reduce the specific surface area of crystals. The necking treatment in this manner helps the resulting dye-sensitized solar cell to have a high photoelectric conversion efficiency.

The dispersion of peroxo-modified titanium oxide of anatase type should contain solids in concentrations from 0.1 wt% to 3.0 wt%, preferably from 0.5 wt% to 2.5 wt%. With concentrations lower than 0.1 wt%, it will not permit complete bonding between titanium dioxide particles in the titanium dioxide layer. This makes it necessary to repeat the dipping or coating of the titanium dioxide layer in or with the dispersion of peroxo-modified titanium oxide of anatase type, which leads to low productivity.

With concentrations higher than 3.0 wt%, it will be poor in storage stability and it causes the solids to excessively cover the porous titanium dioxide layer 3, thereby reducing the specific surface area thereof, which leads to reduced dye adsorption and low power generating efficiency.

Incidentally, the concentration of solids in the dispersion of peroxo-modified titanium oxide of anatase type means the ratio (by weight) of all solutes to the solution measured when the solution is prepared or the ratio (by weight) of solids to the solution measured after the solution has been dried.

The dispersion of peroxo-modified titanium oxide of anatase type should contain titanium oxide particles of certain size, ranging from 1 nm to 100 nm, preferably 3 nm to 50 nm, when it is used for the dipping of the porous titanium dioxide layer 3. Moreover, it should contain the particles of peroxo-modified titanium oxide of anatase type which have their surface modified with peroxo groups.

A probable reason for the necessity of specific particle size is as follows. With a particle size smaller than 3 nm, the particles of peroxo-modified titanium oxide of anatase type do not provide conducting pass sufficiently when they come into contact with the titanium oxide of the porous titanium dioxide layer 3 which do not possess sufficient conductivity.

With a particle size larger than 50 nm, the particles of peroxo-modified titanium oxide of anatase type are buried in the pores of the porous titanium dioxide layer 3, with the result that the porous titanium dioxide layer 3 decreases in specific surface area, the amount of dye adsorption decreases, and the power generating efficiency decreases.

The peroxo-modified titanium oxide of anatase type can be measured for its particle diameter by drying its dispersion at room temperature and photographing the resulting powder by means of a transmission electron microscope (TEM). The result is expressed in terms of an average of several measurements taken in different directions in the microphotograph.

In this embodiment, however, the average particle diameter is obtained by examining the dried powder which is obtained from solution of peroxo-modified titanium oxide of anatase type by drying in the room temperature for X-ray diffraction pattern and calculating the crystal diameter from the half-width of the diffraction peak due to the (101) plane according to Scherrer formula. The thus obtained crystal particle is regarded as the average particle diameter.

### (Drying of porous titanium dioxide layer)

The dipping of the porous titanium dioxide layer 3 in a dispersion of peroxo-modified titanium oxide of anatase type is followed by drying in the atmospheric air at 50°C to 150°C for 15 to 60 minutes. The drying conditions are not specifically restricted.

### [The third step: for baking the porous titanium dioxide layer]

After drying (mentioned above), the porous titanium dioxide layer 3 is baked in the atmospheric air or oxygen atmosphere, so that the particles of peroxo-modified titanium oxide of anatase type which have attached themselves to the porous titanium dioxide layer 3 as the result of dipping lose the peroxogroups and change into the particles of titanium dioxide of anatase type, with titanium dioxide particles bonding with one anther through surface contact structure.

### [The fourth step: for allowing the porous titanium dioxide layer to support the dye]

This step is intended to allow the porous titanium dioxide layer 3, which has undergone the third step, to adsorb the dye.

### (Sensitizing dye)

The organic dye (spectral sensitizing dye) to be adsorbed on the porous titanium dioxide layer 3 is one which has absorption in the visible region and/or infrared region. It may be one or more than one kind of metal complex or organic dye. Preferable among the spectral sensitizing dyes are those which have in the molecule such functional groups as carboxyl group, hydroxyalkyl group, hydroxyl group, sulfonyl group, and caroxylalkyl groups. They are rapidly adsorbed to the semiconductor. Metal complexes are preferable because of their good spectral sensitizing effect and durability.

The metal complexes that can be used in this embodiment include metal phthalocyanine (such as copper phthalocyanine and titanyl phthalocyanine), chlorophyll, and hemin. They also include complexes of ruthenium, osmium, iron, and zinc, which are disclosed in Patent Documents 1 and 2.

The organic dyes include metal-free phthalocyanine dye, cyanine dye, merocyanine dye, xanthene dye, and triphenylmetane dye. Typical examples of the cyanine dye include NK1194 and NK3422 (both from Japanese Res. inst. for Photosensitizing Dyes Co., Ltd) . Typical examples of the merocyanine dye include NK2426 and NK2501 (both from Japanese Res. inst. for Photosensitizing Dyes Co., Ltd). Typical examples of the xanthene dye include uranine, eosine, rose bengal, rhodamine B, and dibromofluorescein. Typical examples of the tripheynlmethane include malachite green and crystal violet.

For the porous titanium dioxide layer 3 to adsorb the organic dye (spectral sensitizing dye), the transparent substrate 1 supporting it thereon is dipped in a solution of the organic dye in water or organic solvent at normal temperature or with heating. Any organic solvent can be used so long as it dissolves the spectral sensitizing dye; it includes, for example, alcohol, toluene, dimethylformamide, chloroform, ethylcellosolve, N-methylpyrrolidone, and tetrahydrofuran. A 1:1 mixture of t-butanol and acetonitrile is desirable.

No specific restrictions are imposed on the method for adsorption of the sensitizing dye on the porous titanium oxide layer 3. Ordinary method is by application of the above-mentioned dye solution to the porous titanium dioxide layer 3 by dipping, spinning, or spraying, followed by drying. These steps may be repeated according to need. Dipping may be accomplished with the dye solution refluxing.

### [The fifth step: for filling the space between the working electrode and the counter electrode with the electrolyte layer]

The fifth step is intended to fill the space between the porous titanium dioxide layer 3 and the counter electrode 4 (which are arranged opposite to each other) with the electrolyte layer 6.

### (Counter electrode)

The counter electrode 4 may be formed on an insulating substrate of glass or organic polymer, such as PET, or a conductive substrate of titanium, aluminum, copper, or nickel.

The counter electrode 4 may be formed from a conductive material by any known method, such as thermal decomposition and CVD. The conductive material should preferably be capable of rapidly catalyzing the reduction reaction of the redox ions of oxide type, such as I₃⁻ ions of the electrolyte.

Examples of such a material include platinum, rhodium, ruthenium oxide, carbon, cobalt, nickel, and chromium. One of these materials is made into the counter electrode 4 by plating or vapor deposition on the surface of a conductive material, such as tin oxide, Sb-, F-, or P-doped tin oxide, Sn- and/or F-doped indium oxide, and antimony oxide.

### (Electrolyte layer)

The electrolyte layer 6 is formed from an electrolyte which is a mixture of an electrochemically active salt and at least one compound that forms on oxidation reduction system with the salt.

Examples of the electrochemically active salt include quaternary ammonium salts, such as tetrapropylammonium iodide. Examples of the compound that forms the oxidation reduction system include quinone, hydroquinone, iodine (I⁻/I₃⁻), and potassium bromide. They may be used in combination with one another.

The electrolyte mentioned above may be used in an amount ranging from 0.1 mol/L to 5 mol/L, depending on the type of the electrolyte and the solvent therefor (mentioned later).

The electrolyte may be dissolved in any known solvent, which includes water, alcohols, oligoethers, carbonates (such as propioncarbonate), phosphoric esters, dimethylformamide, dimethylsulfoxide, N-methylpyrrolidone, N-vinylpyrrolidone, sulfur compound (such as sulfolane 66), ethylene carbonate, acetonitrile, and γ-butyrolactone.

The electrolyte may also be dissolved in an ionic liquid, which is a molten salt at normal temperature. It has a high ion concentration and a high ion mobility, and hence it exhibits an extremely high ionic conductivity. Thus it is suitable for use as the matrix of the electrolyte.

Examples of the ionic liquid include imidazolium salt, pyridinium salt, ammonium salt, 2-methyl-1-pyrroline, 1-methylpyrazole, and 1-ethylcarbozole. They may be used in the form of polymer or gel according to need.

The electrolyte solution may optionally contain an ion conduction promoting agent, which is selected from a group consisting of titanium oxide nanotube, fibrous titanium oxide, and carbon nanotube. This agent promotes ion conduction and help the solar cell to exhibit a high photoelectric conversion efficiency. A probable reason for this is that it takes on a linear elongated form on which the electrolyte molecules orient, providing the shortest passage for electrons and ions to conduct.

The electrolyte solution may be in the form of gel. This poses no problem at all. The gelled electrolyte solution is rather desirable because it is free of leakage. In addition, according to this embodiment, the electrolyte solution may be replaced by a solid electrolyte.

Desirable examples of the solid electrolyte include CuI, CuBr, CuSCN, polyaniline, polypyrrol, polythiophene, arylamine polymer, polymers containing acryl group and/or methacryl group, polyvinylcarbazole, triphenyldiamine polymer, low molecular weight gel of L-valine derivative, polyoligoethylene glycol methacrylate, poly(o-methoxy aniline), poly(epichlorohydrin-Co-ethylene oxide), 2,2',7,7'-tetorakis(N,N-di-P-methoxyphenyl-amine)-9,9'-spirobifluorene, fluorine-based ion-exchange resin having proton conductivity (such as perfluorosulfonate), perfluorocarbon copolymer, and perfluorocarbonsulfonic acid. Additional examples include polyethylene oxide and polymers formed from counter ion (composed of imidazole cation and any of Br⁻, BF₄⁻, and N-(SO₂CF₃)₂) and vinyl monomer and PMMA monomer (by ion gel process).

The photoelectric cell containing the solid electrolyte is produced in the following manner. First, the components constituting the solid electrolyte are dissolved or dispersed in a solvent, and the resulting solution is incorporated with the ion conduction promoting agent. Then, the thus obtained solution containing the electrolyte is injected through the inlet into the space between the electrodes. The solvent is removed, if necessary. Finally, the inlet is sealed. Incidentally, the solid electrolyte used in this embodiment includes gel-like electrolyte.

The electrolyte in gel form should have a viscosity no lower than 1000 cp, preferably no lower than 2000 cp, and no higher than 10,000 cp. The electrolyte having a viscosity higher than 1000 cp is not lost and helps the photoelectric conversion efficiency to remain constant over a long period of use. Moreover, it does not cause corrosion.

The electrolyte layer contains the ion conduction promoting agent in an amount (as solids) of 5 wt% to 40 wt%, preferably 10 wt% to 30 wt%. The content within the specified range is sufficient to achieve gelation and produce the ion conduction promoting effect.

### (Sealing material)

The sealing material 5 any one of thermosetting resins (such as UV curable acrylic resin, UV curable epoxy resin, and epoxy resins) and heat-sealable resins (such as ionomer).

The following description is about the dye-sensitized solar cell and the process for production thereof. The process mentioned below includes the first Ti treatment step, by which the leakage current suppressing layer is formed in the FTO layer by means of a Ti-containing aqueous solution (an aqueous solution containing a Ti compound), and the second Ti treatment step, by which the TiO₂ layer is dipped in the Ti-containing aqueous solution.

### [The second embodiment]

In order to address problems involved in the existing technologies, the present inventors carried out a series of researches which led to a finding that there is obtained a dye-sensitized solar cell with an improved power generating efficiency if the titanium oxide layer is formed by coating or printing from a titanium oxide paste containing spindle-shaped particles of peroxo-modified titanium oxide of anatase type.

It is conjectured that a titanium oxide paste containing spindle-shaped particles of peroxo-modified titanium oxide of anatase type provides not only firm bonding between the transparent conductive layer and the titanium dioxide layer at their interface and in the vicinity thereof but also firm bonding between particles of titanium dioxide within the titanium dioxide layer which are away from the transparent conductive layer.

### (Structure of the dye-sensitized solar cell)

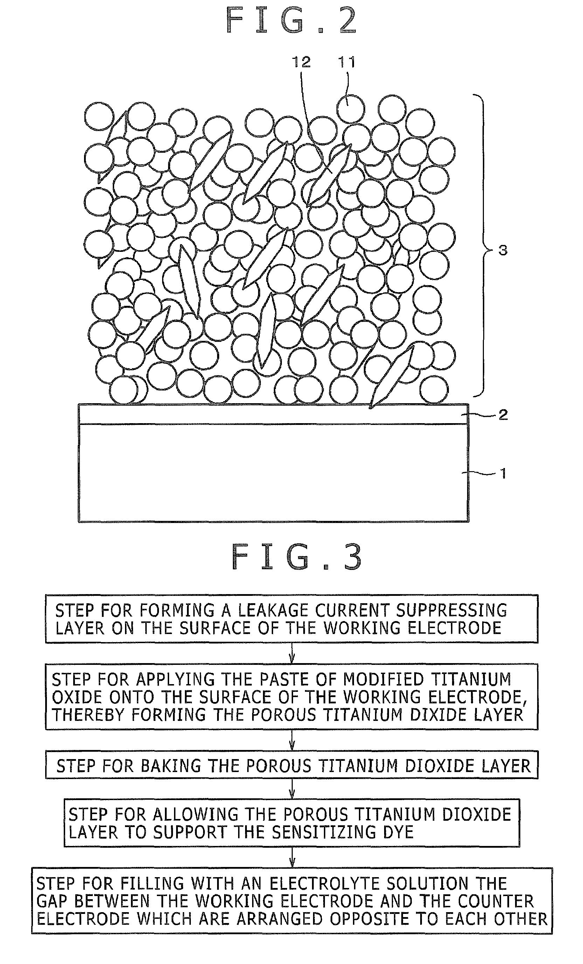

Fig. 2 is a diagram illustrating the structure of the porous titanium dioxide layer in the dye-sensitized solar cell pertaining to the second embodiment of the present disclosure. As shown in Fig. 2, the dye-sensitized solar cell pertaining to the second embodiment has the porous titanium dioxide layer 3 which contains spherical particles 11 of titanium oxide of anatase type and spindle-shaped particles 12 of titanium oxide of anatase type.

According to this embodiment, the titanium oxide particles are composed of spherical ones and spindle-shaped ones. The combination of two kinds of particles results in an increased bonding area for titanium oxide particles. The spherical and spindle-shape particles of titanium oxide have the same crystal structure (that is, the crystal structure of anatase type), so that they form necking in the baking step and give rise to a matched crystal lattice at the interface between bonded particles. The fact that both the spherical and spindle-shaped particles are of anatase type contributes to a better conversion efficiency than in the case where the titanium oxide particles are of rutile type.

It is desirable that the spherical particle 11 of titanium oxide of anatase type and the spindle-shaped particle 12 of titanium oxide of anatase type, which are adjacent to each other, should bond with each other. Moreover, this bonding should preferably be face-to-face bonding, so that their bonding forms a good conducting pass.

The bonding of the adjacent particles should give a matched crystal lattice in their interface so that it forms a good conducting pass.

A better conducing pass will be achieved if each crystal is formed from more than one spherical particle 11 of titanium oxide of anatase type and more than one spindle-shaped particle 12 of titanium oxide of anatase type. In this case, the two kinds of particles orient in the same direction and give a matched crystal lattice in their interface.

Except for the foregoing, the dye-sensitized solar cell in the second embodiment is identical with that in the first embodiment mentioned above.

### (Process for production of the dye-sensitized solar cell)

The process for producing the dye-sensitized solar cell will be described in more detail with reference to Fig. 3.

### [Formation of the leakage current suppressing layer]

First, the surface of the transparent conductive layer 2 is optionally treated with a Ti-containing aqueous solution, such as an aqueous solution of TiCl₄, a dispersion of peroxotitanic acid, and a dispersion of peroxo-modified titanium oxide of anatase type. This treatment forms the leakage current suppressing layer on the surface of the transparent conductive layer 2.

### [Formation of the porous titanium dioxide layer]

Then, the transparent conductive layer 2, which has been formed on the transparent substrate 1, is coated with a paste of modified titanium oxide containing spindle-shaped particles of peroxo-modified titanium oxide of anatase type, by any suitable method including printing. This coating step may optionally be followed by drying to remove the solvent. In this way, there is obtained the porous titanium dioxide layer 3 formed on the transparent conductive layer 2.

Coating with a paste of modified titanium oxide may be accomplished by any method which is simple and suitable for mass production. Typical coating methods include roll coating, dip coating, air knife coating, blade coating, wire bar coating, slide hopper coating, extrusion coating, curtain coating, spin coating, spray coating, microgravure coating, direct gravure coating, and comma coating, which are not limitative. Printing methods for coating include letterpress printing, offset printing, gravure printing, intaglio printing, rubber plate printing, and screen printing, which are not limitative.

Drying may be accomplished by any method, such as natural drying or artificial drying at a controlled temperature for a controlled period. The temperature and duration of artificial drying should be established in consideration of the heat resistance of the transparent substrate 1, so that drying does not adversely affect the transparent substrate 1. Artificial drying should preferably be carried out at 50°C to 150°C for 15 to 60 minutes.

### (Paste of modified titanium oxide)

The paste of modified titanium oxide is composed of spherical particles of titanium oxide of anatase type, spindle-shaped particles of peroxo-modified titanium oxide of anatase type, and a solvent. It may optionally contain a polymer, surfactant, acid, or chelating agent as a dispersing agent.

The paste of modified titanium oxide may be prepared by dispersing into a solvent spindle-shaped particles (in powder form) of peroxo-modified titanium oxide of anatase type and spherical particles (in powder form) of titanium oxide of anatase type. An alternative method includes kneading spindle-shaped particles (in power form) of peroxo-modified titanium oxide of anatase type into a previously prepared paste of titanium oxide. The previously prepared paste of titanium oxide is not specifically restricted. It may be prepared by dispersing into a solvent spherical particles (in powder or sol form) of titanium oxide of anatase type. The solvent may optionally contain an thickening agent, acid, or alkali. The previously prepared paste of titanium oxide is commercially available.

Dispersion into a solvent may be accomplished by any known method, such as stirring, ultrasonic dispersion, beads dispersion, kneading, and homogenizing, which are not limitative.

The paste of modified titanium oxide should contain titanium oxide particles such that the ratio (by weight) of spindle-shaped particles of peroxo-modified titanium oxide of anatase type to the sum of spherical particles of titanium oxide of anatase type and spindle-shaped particles of peroxo-modified titanium oxide of anatase type is in the range of 5 wt% to 30 wt%. Calculations are based on the amount of titanium oxide particles. With a ratio lower than 5%, the paste of modified titanium oxide does not provide the desirable necking effect and hence the resulting solar cell is poor in conversion efficiency. With a ratio higher than 30 wt%, the paste of modified titanium oxide undergoes excessive necking, with the result that the sensitizing dye is not sufficiently adsorbed by the spherical and spindle-shaped particles of titanium oxide and the electrolyte solution does not completely infiltrate into the porous titanium dioxide layer 3, which leads to a low conversion efficiency.

### (Spherical particles of titanium oxide of anatase type)

The spherical particles 11 of titanium oxide of anatase type should have an average particle diameter of 5 to 250 nm, preferably 5 to 100 nm, more preferably 5 nm to 50 nm. If the average particle diameter is smaller than 5 nm, the porous titanium dioxide layer 3 is too compact to permit the electrolyte solution to smoothly infiltrate into it thereby increasing the resistance. If the average particle diameter is larger than 250 nm, the porous titanium dioxide layer 3 has a small specific surface area, which leads to insufficient adsorption of the sensitizing dye and a low power generating efficiency.

The particles may take on an approximately spherical shape, an approximately ellipsoidal shape, or an approximately polyhedral shape, with the former two being desirable. "Spherical" includes truly spherical, slightly flattened or distorted spherical, and spheres with surface irregularities. "Ellipsoidal" means truly ellipsoidal, slightly flattened or distorted ellipsoidal, and ellipsoids with surface irregularities. "Polyhedral" means truly polyhedral, slightly flattened or distorted polyhedral, and polyhedral bodies with surface irregularities. In the case of particles of spherical shape or ellipsoidal shape having the long axis and the short axis, the ratio of the average long axis to the average short axis should preferably be in the range of 1 to 1.5.

The spherical particles 11 of titanium oxide of anatase type are examined for average particle diameter by means of X-ray diffraction pattern and the crystal diameter is calculated from the half-width of the diffraction peak due to the (101) plane according to Scherrer formula. The thus obtained crystal diameter is regarded as the average particle diameter.

### (Spindle-shaped particles of peroxo-modified titanium oxide of anatase type)

The spindle-shaped particles of peroxo-modified titanium oxide of anatase type are particles of titanium oxide of anatase type having their surface at least partly modified with -Ti-O-OH. Modification with -Ti-O-OH may be made on a portion of the surface, but it should preferably be made over the entire surface so that it contributes to improvement in the power generation characteristics. The peroxo group (-O-O-) on the surface of the titanium oxide particle promotes reaction between the spindle-shaped particles of peroxo-modified titanium oxide of anatase type and the spherical particles of titanium oxide of anatase type, so that the two kinds of particles undergo good necking (bonding) and provide a matched crystal lattice at the interface between them.

The spindle-shaped particles of peroxo-modified titanium oxide of anatase type may contain titanium dioxide as the major component. They may also contain as minor components at least one species of water-containing titanium oxide, hydrated titanium oxide, orthotitanic acid, metatianic acid, and titanium hydroxide. They may additionally contain in their inside or on their surface such elements as silicon, titanium, aluminum, zirconium, tin, and iron and such inorganic compounds as oxides and phosphates of the elements. They have the crystal structure of anatase type, so that they contribute to a better conversion efficiency than those particles of rutile type.

"Spindle-shape" also embraces acicular shape, columnar shape (such as hexagonal), rodlike shape, and fibrous shape. These shapes may be slightly flattened or distorted or have surface irregularities. Incidentally, the particle shape may be identified by observation under an electron microscope or a transmission electron microscope.

The spindle-shaped particles of peroxo-modified titanium oxide of anatase type should preferably be those which have a wide smooth crystal surface so that they undergo necking easily with the spherical particles of titanium oxide of anatase type. Moreover, the spindle-shaped particles of peroxo-modified titanium oxide of anatase type should preferably have an average particle diameter (or an average long axis diameter) which varies depending the average particle diameter of the spherical particles of titanium oxide of anatase type as the major component of the paste of modified titanium oxide.

The spindle-shaped particles of peroxo-modified titanium oxide of anatase type should have an average particle diameter of about 5 nm to 250 nm, preferably about 10 nm to 100 m. Those having an average particle diameter smaller than 5 nm make the porous titanium dioxide layer 3 excessively compact and have a small surface area, which reduces the amount of adsorption of the sensitizing dye and adversely affects the performance of the solar cell. By contrast, those having an average particle diameter in excess of 250 nm precipitate in the paste of modified titanium oxide and hardly enter interstices in the TiO₂ electrode. This is detrimental to the performance of the solar cell.

The spindle shape is defined by the average long-axis diameter of 30 nm to 100 nm and the average short-axis diameter of 5 nm to 20 nm. The spindle-shaped particles of peroxo-modified titanium oxide of anatase type aggregate if their average short axis diameter is smaller than 5 nm and lower the transmittance of visible light and give rise to voids if their average long axis diameter is longer than 100 nm. They should have an average ratio of long-axis diameter to short-axis diameter which is larger than 1.5, preferably in the range of 2 to 20, more preferably 3 to 9.

The spindle-shaped particles of peroxo-modified titanium oxide of anatase type are examined for average long-axis particle diameter (a) and average short-axis diameter (b) by the following procedure, with the ratio (a)/(b) representing the their average axial ratio.

The first step is to prepare a dispersion of spindle-shaped particles of peroxo-modified titanium oxide of anatase type. Then, the dispersion is dried at room temperature. The resulting power is observed and photographed under a transmission electron microscope (TEM). The image of a single particle of the spindle-shaped peroxo-modified titanium oxide of anatase type is selected from the micrograph and examined for its short-axis diameter and long-axis diameter. This procedure is repeated for ten particles randomly selected from the microphotograph. The measurements are averaged to give the long-axis diameter (a) and short-axis diameter (b) in terms of arithmetic method. The average axial ratio is expressed by (a) / (b) .

The spindle-shaped particles of peroxo-modified titanium oxide of anatase type are examined for average particle diameter by means of X-ray diffraction pattern (obtained from a powder that remains after the dispersion is dried), and the crystal diameter is calculated from the half-width of the diffraction peak due to the (101) plane according to Scherrer formula. The thus obtained crystal diameter is regarded as the average particle diameter.

The spindle-shaped particles of peroxo-modified titanium oxide of anatase type (in powder form) can be produce by either of the following methods.

Method 1: First, a dispersion of peroxotitanic acid is prepared by dispersing peroxotitanic acid into water, optionally together with an amine-containing organic compound. Then, the resulting dispersion is heated for crystallization, so that there is obtained a dispersion containing spindle-shaped particles of peroxo-modified titanium oxide of anatase type. The particles of titanium oxide take on the spindle shape if crystallization is accomplished under adequate conditions (temperature, pressure, etc.) The thus obtained dispersion is evaporated to dryness to yield the spindle-shaped particles of peroxo-modified titanium oxide of anatase type (in powder form).

Method 2: A powder or sol of spindle-shaped particles of titanium oxide of anatase type is added to a dispersion of peroxotitanic acid, optionally together with an amine-containing organic compound. Then, the resulting mixture is heated so that the peroxo titanic acid sticks to the surface of the spindle-shaped particles of titanium oxide of anatase type. The resulting product is a dispersion of spindle-shaped particles of peroxo-modified titanium oxide of anatase type. This dispersion is evaporated to dryness. In this way there is obtained a powder of peroxo-modified titanium oxide of anatase type.

### (Solvent)

The solvent is water or organic solvent, such as methanol, ethanol, isopropyl alcohol, dichloromethane, acetone, acetonitrile, and ethyl acetate. They may be used alone or in combination with one another.

### [Baking of the porous titanium dioxide layer]

The porous titanium dioxide layer prepared as mentioned above is baked in the atmospheric air or an oxygen atmosphere. Upon baking, the spindle-shaped particles of peroxo-modified titanium oxide of anatase type, which are contained the porous titanium dioxide layer 3, lose the peroxo groups and change into the spindle-shaped particles of titanium oxide of anatase type. Baking also brings about bonding (in surface contact structure) between the spindle-shaped particles of titanium oxide of anatase type and the spherical particles of titanium oxide of anatase type. The thus bonded particles of titanium oxide have a matched crystal lattice at the interface between them.

Baking may be accomplished in any manner in the atmospheric acid or an oxygen atmosphere at 250°C to 700°C, preferably 350°C to 600°C, for 10 to 360 minutes. Baking below 250°C does not yield crystals of titanium oxide of anatase type; this is undesirable for the leakage current suppressing layer to become sufficiently compact. By contrast, baking above 700°C changes the crystal structure from anatase type (which is desirable) to rutile type or causes the particles of titanium oxide to aggregate, thereby reducing their specific surface area. Baking may be repeated more than once.

After the subsequent steps identical with those in the first embodiment, there is obtained the dye-sensitized solar cell.

The second embodiment provides a process for producing the dye-sensitized solar cell having a lower internal resistance and a high photoelectric conversion efficiency simply by coating, followed by baking, a transparent conductive film with a paste of titanium oxide containing spindle-shaped particles of peroxo-modified titanium oxide of anatase type. This process eliminates treatment with an aqueous solution of TiCl₄ which follows the baking step in the existing technologies. This is desirable for environmental protection and cost reduction.

The titanium oxide paste which is incorporated with spindle-shaped particles of peroxo-modified titanium oxide of anatase type helps produce the dye-sensitized solar cell which has a greatly improved power generating efficiency and excels the existing one, in which the porous titanium dioxide layer 3 is treated with an aqueous solution of TiCl₄, by means of an environment-friendly economical equipment.

### Examples

The following illustrates Examples 1 to 21, which involve the processes and materials common to them as mentioned first below.

### [Preparation of dispersion of peroxotitanic acid]

A dispersion of peroxotitanic acid was prepared by dissolving 5.5 g of titanium tetrachloride in 250 mL of distilled water, adding dropwise 100 mL of 2.8% ammonia water to the solution to give white precipitates, filtering the precipitates to obtain titanium hydroxide, washing the titanium hydroxide with distilled water, adding the titanium hydroxide to 200 mL of distilled water, adding dropwise 20 mL of 15 wt% hydrogen peroxide water to the solution to give a yellowish solution of peroxotitanic acid, and adding pure water to the solution so that the solution contains 1 wt% solids (in terms of TiO₂). Thus, there was obtained a dispersion of peroxotitanic acid.

The thus obtained dispersion of peroxotitanic acid was allowed to evaporate to dryness at room temperature. The resulting yellowish powder was tested for X-ray diffraction (XRD) by using PINT TTRII made by Rigaku Corporation. It was found that the sample was amorphous. This suggests that the dispersion of peroxotitanic acid contains amorphous particles. Incidentally, diffraction patterns were taken with the help of X-rays emitted from a copper target with an accelerating voltage of 50 kV and a current of 300 mA.

### [Preparation of dispersion of peroxo-modified titanium oxide of anatase type]

A dispersion containing particles of peroxo-modified titanium oxide of anatase type was prepared in the following manner.

### (Dispersion containing peroxo-modified titanium oxide of anatase type in the form of spherical particles with an average particle diameter of 3 nm)

The yellowish dispersion of peroxotitanic acid mentioned above was allowed to stand for 24 hours and then concentrated by heating (at 60°C) in an evaporator to give a dispersion containing peroxo-modified titanium oxide of anatase type in the form of spherical particles. After dilution with pure water, there was obtained a dispersion of peroxo-modified titanium oxide of anatase type which contains 1 wt% solids (in terms of TiO₂).

The thus obtained dispersion of peroxo-modified titanium oxide of anatase type was allowed to evaporate to dryness at room temperature. The resulting yellowish powder was tested for X-ray diffraction (XRD) under the same conditions as above. Peaks due to anatase were noticed in the diffraction pattern.

The above-mentioned dispersion of peroxo-modified titanium oxide of anatase type was found to contain particles of peroxo-modified titanium oxide of anatase type having an average particle diameter of 3 nm (which is equivalent to the crystal diameter obtained from the half-width value of the diffraction peak due to the (101) plane according to Scherrer formula).

### (Dispersion containing peroxo-modified titanium oxide of anatase type in the form of spherical particles with an average particle diameter of 5 nm)

The yellowish dispersion of peroxotitanic acid mentioned above was allowed to stand for 24 hours and then heated at 60°C for five hours to give a dispersion containing peroxo-modified titanium oxide of anatase type in the form of spherical particles. After dilution with pure water, there was obtained a dispersion of peroxo-modified titanium oxide of anatase type which contains 1 wt% solids (in terms of TiO₂).

The thus obtained dispersion of peroxo-modified titanium oxide of anatase type was allowed to evaporate to dryness at room temperature. The resulting yellowish powder was tested for X-ray diffraction (XRD) under the same conditions as above. Peaks due to anatase were noticed in the diffraction pattern.

The above-mentioned dispersion of peroxo-modified titanium oxide of anatase type was found to contain particles of peroxo-modified titanium oxide of anatase type having an average particle diameter of 5 nm (which is equivalent to the crystal diameter obtained from the half-width value of the diffraction peak due to the (101) plane according to Scherrer formula).

### (Dispersion containing peroxo-modified titanium oxide of anatase type in the form of spherical particles with an average particle diameter of 10 nm)

The yellowish dispersion of peroxotitanic acid mentioned above was stirred at room temperature for 24 hours and then heated at 100°C for five hours to give a dispersion containing peroxo-modified titanium oxide of anatase type in the form of spherical particles. After dilution with pure water, there was obtained a dispersion of peroxo-modified titanium oxide of anatase type which contains 1 wt% solids (in terms of TiO₂).

The thus obtained dispersion of peroxo-modified titanium oxide of anatase type was allowed to evaporate to dryness at room temperature. The resulting powder was made into a tablet sample by mixing with KBr. The tablet sample was tested for FT-IR spectrum by transmission method with a Fourier transform infrared absorption spectrometer, Model NEXUS470, made by Thermo Fisher Scientific Inc.

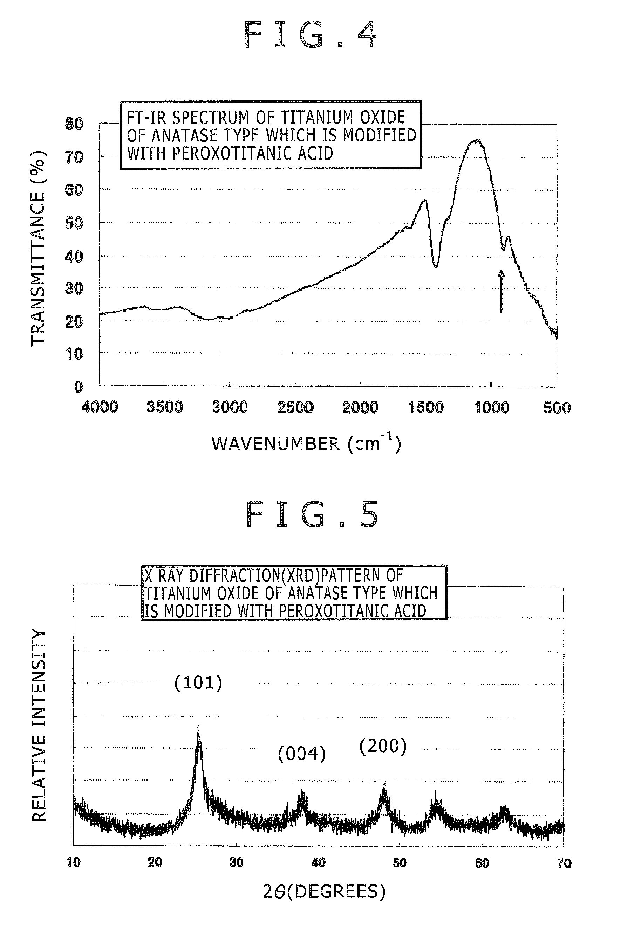

The tablet sample gave a FT-IR spectrum as shown in Fig. 4, in which the abscissa represents the wavenumber (cm⁻¹) and the ordinate represents the transmittance (%).

It is to be noted from Fig. 4 that the FT-IR spectrum has an absorption peak in the neighborhood of 900 cm⁻¹, which is characteristic of the peroxo group.

The thus obtained dispersion of peroxo-modified titanium oxide of anatase type was allowed to evaporate to dryness at room temperature. The resulting yellowish powder was tested for X-ray diffraction (XRD) under the same conditions as above.

The yellowish powder gave an X-ray diffraction (XRD) pattern as shown in Fig. 5, in which the abscissa represents the scattering angle 2θ (degrees) and the ordinate represents the relative intensity (in arbitrary units).

The X-ray diffraction pattern in Fig. 5 gave peaks attributable to anatase. The dispersion of peroxo-modified titanium oxide of anatase type was found to contain particles of peroxo-modified titanium oxide of anatase type having an average particle diameter of 10 nm (which is equivalent to the crystal diameter obtained from the half-width value of the diffraction peak due to the (101) plane according to Scherrer formula).

The dispersion of peroxo-modified titanium oxide of anatase type was dropped onto a film and then allowed to dry at room temperature. The resulting powder was photographed by a transmission electron microscope (TEM).

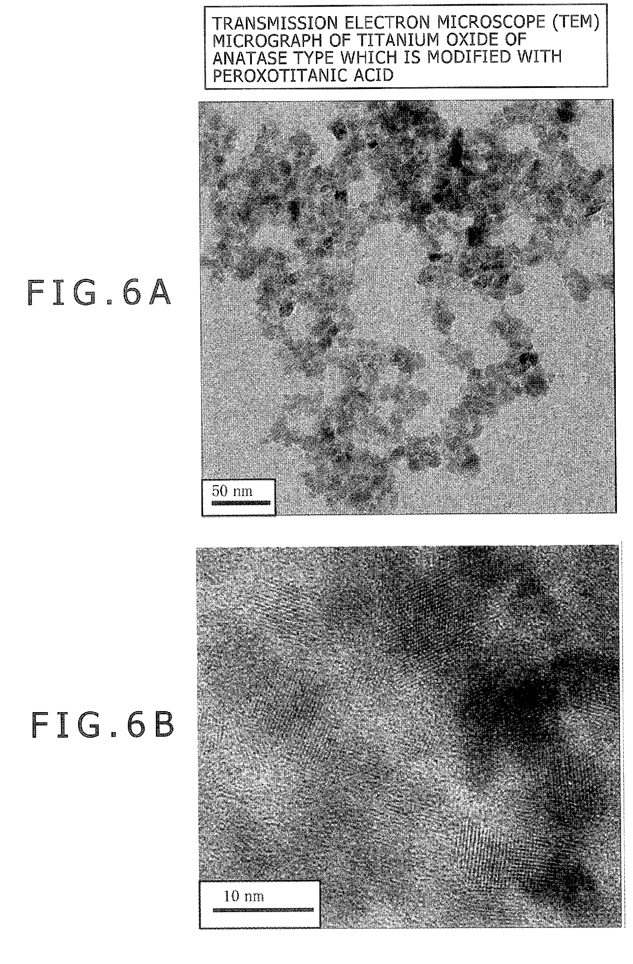

The resulting micrograph is shown in Figs. 6A and 6B, whose scales are indicated by bars for 50 nm and 10 nm.

Fig. 6A shows the peroxo-modified titanium oxide of anatase type in the form of approximately spherical particles with an average particle diameter of 10 nm. Fig. 6B apparently shows the image of crystal lattice.

### (Dispersion containing peroxo-modified titanium oxide of anatase type in the form of spherical particles with an average particle diameter of 40 nm)

The yellowish dispersion of peroxotitanic acid mentioned above was heated at 100°C for one hour and then subjected to hydrothermal treatment at 150°C for three hours in a heat-resistant autoclave to give a dispersion containing spherical particles of peroxo-modified titanium oxide of anatase type. After dilution with pure water, there was obtained a dispersion of peroxo-modified titanium oxide of anatase type which contains 1 wt% solids (in terms of TiO₂).

The thus obtained dispersion of peroxo-modified titanium oxide of anatase type was allowed to evaporate to dryness at room temperature. The resulting yellowish powder was tested for X-ray diffraction (XRD) under the same conditions as above. Peaks due to anatase were noticed in the diffraction pattern.

The above-mentioned dispersion of peroxo-modified titanium oxide of anatase type was found to contain particles of peroxo-modified titanium oxide of anatase type having an average particle diameter of 40 nm (which is equivalent to the crystal diameter obtained from the half-width value of the diffraction peak due to the (101) plane according to Scherrer formula).

### (Dispersion containing peroxo-modified titanium oxide of anatase type in the form of spherical particles with an average particle diameter of 50 nm)

The yellowish dispersion of peroxotitanic acid mentioned above was heated at 100°C for one hour and then subjected to hydrothermal treatment at 180°C for five hours in a heat-resistant autoclave to give a dispersion containing spherical particles of peroxo-modified titanium oxide of anatase type. After dilution with pure water, there was obtained a dispersion of peroxo-modified titanium oxide of anatase type which contains 1 wt% solids (in terms of TiO₂).

The thus obtained dispersion of peroxo-modified titanium oxide of anatase type was allowed to evaporate to dryness at room temperature. The resulting yellowish powder was tested for X-ray diffraction (XRD) under the same conditions as above. Peaks due to anatase were noticed in the diffraction pattern.

The above-mentioned dispersion of peroxo-modified titanium oxide of anatase type was found to contain particles of peroxo-modified titanium oxide of anatase type having an average particle diameter of 50 nm (which is equivalent to the crystal diameter obtained from the half-width value of the diffraction peak due to the (101) plane according to Scherrer formula).

### (Dispersion containing peroxo-modified titanium oxide of anatase type in the form of spherical particles with an average particle diameter of 100 nm)

The yellowish dispersion of peroxotitanic acid mentioned above (100 mL) was given 2 g of titanium oxide of anatase type in the form of spherical particles with an average particle diameter of 80 nm, and the mixture was heated at 60°C for one hour. After additional heating at 100°C for one hour, it was subjected to hydrothermal treatment at 180°C for five hours in a heat-resistant autoclave to give a dispersion containing spherical particles of peroxo-modified titanium oxide of anatase type. After dilution with pure water, there was obtained a dispersion of peroxo-modified titanium oxide of anatase type which contains 1 wt% solids (in terms of TiO₂) .

The thus obtained dispersion of peroxo-modified titanium oxide of anatase type was allowed to evaporate to dryness at room temperature. The resulting yellowish powder was tested for X-ray diffraction (XRD) under the same conditions as above. Peaks due to anatase were noticed in the diffraction pattern.

The above-mentioned dispersion of peroxo-modified titanium oxide of anatase type was found to contain particles of peroxo-modified titanium oxide of anatase type having an average particle diameter of 100 nm (which is equivalent to the crystal diameter obtained from the half-width value of the diffraction peak due to the (101) plane according to Scherrer formula).

### [The first Ti treatment: Formation of the leakage current suppressing layer]

A glass plate as the transparent substrate was coated with an FTO layer (1000 nm thick having a sheet resistance of 10 Ω/□) by CVD. The coated substrate was dipped in an aqueous solution containing Ti in the form of peroxotitanic acid, peroxo-modified titanium oxide of anatase type, or titanium tetrachloride. The aqueous solution was kept at 70°C for 20 minutes. Dipping was followed by rinsing with pure water to remove a surplus of the Ti-containing aqueous solution. After drying, the FTO layer became coated with a thin film of TiO₂ as the leakage current suppressing layer. This TiO₂ layer improves conductivity between the FTO layer and the titanium dioxide layer.

Incidentally, the first Ti treatment employed a dispersion of peroxo-modified titanium oxide of anatase type in Examples 1 to 17, and an aqueous solution of titanium tetrachloride in Examples 19 to 21.

### [Formation of TiO₂ layer]

The FTO layer which has been treated with a Ti-containing aqueous solution was coated with titanium oxide paste (PST-24NRT, from Catalysts & Chemicals Ind. Co., Ltd.) by screen printing. This coating gave a 12 µm thick layer composed of fine particles. The coating step was followed by baking at 500°C for 60 minutes. In this way, the TiO₂ layer 3 was formed on the FTO layer.

### [Pretreatment of TiO₂ layer]

The TiO₂ layer was irradiated with ultraviolet rays (172 nm) emitted from UV eximer laser (SUS05 made by USHIO INC.) for improvement in wettability.

### [The second Ti treatment: Dipping of TiO₂ layer in Ti-containing aqueous solution]

The TiO₂ layer was dipped in an aqueous solution containing Ti in the form of peroxotitanic acid, peroxo-modified titanium oxide of anatase type, or titanium tetrachloride. Dipping continued at a prescribed temperature for a prescribed period of time. Dipping was followed by rinsing with pure water to remove a surplus of the Ti-containing aqueous solution. After drying, the TiO₂ layer was baked at 500°C for 60 minutes.

Incidentally, the second Ti treatment employed a dispersion of peroxotitanic acid in Examples 1 and 8, a dispersion of peroxo-modified titanium oxide of anatase type in Examples 2 to 7, 9 to 15, and 21, and an aqueous solution of titanium tetrachloride in Examples 16, 18, and 19.

The above-mentioned prescribed temperature was 70°C in Examples 1 to 12, 16, 18, 19, and 21, and 25°C, 50°C, and 90°C in Examples 13 to 15, respectively.

The above-mentioned prescribed period of time was 40 minutes in Example 1 to 7, 13 to 16, 18, 19, and 21, and 120 minutes, 20 minutes, 30 minutes, 60 minutes, and 80 minutes in Examples 8 to 12, respectively.

### [Supporting of the sensitizing dye on the TiO₂ layer]

The following sensitizing dye (*1) and co-adsorbing agent (*2) in a molar ratio of 4:1 were dissolved in a mixed solvent of acetonitrile and tert-butanol in equal volume.
*1 _{:} cis-bis(isothiocyanate)-(2,2'-bipyridine-4,4'-carboxylate)-(2,2'-bipyridine-4,4'-dinonyl)ruthenium (II)
(This is referred to as Z907.)
*2 : 1-decylphosphonic acid (DPA)

In the resulting solution was dipped the TiO₂ layer at room temperature for 24 hours, so that the sensitizing dye was adsorbed to and supported on the surface of the TiO₂ fine particles. The TiO₂ layer was washed with acetonitrile and then freed of solvent by evaporation and drying in a dark place. Thus there was obtained the TiO₂ layer supporting the dye Z907.

### [Assembling of the dye-sensitized solar cell]

The counter electrode was formed by sequentially depositing a chromium layer (500 Å thick) and a platinum layer (1000 Å thick) by sputtering on the FTO layer (1000 nm thick and having a sheet resistance of 10 Ω/□) which is formed on the glass substrate. Incidentally, the counter electrode has a through hole (0.5 mm in diameter) through which the electrolyte solution is injected.

The TiO₂ layer which supports the sensitizing dye Z907 was arranged opposite to the counter electrode, and their periphery was sealed with an ionomer resin film (30 µm thick) and UV curable acrylic resin.

The space between the TiO₂ layer and the counter electrode was filled with an electrolyte solution composed of LiI (0.05 mol/L), methoxypropioimidazolium iodide (1.0 mol/L), iodine I2 (0.10 mol/L), and 1-butylbenzimidazole (NBB) (0.25 mol/L), which was injected via the through hole. After evacuation to remove bubbles, the through hole was sealed with an ionomer resin film and acrylic resin. Thus there was completed the dye-sensitized solar cell 10.

### Example 1 (for comparison)

The FTO layer formed on the glass substrate underwent the first Ti treatment with a dispersion of peroxo-modified titanium oxide of anatase type containing particles with an average particle diameter of 10 nm, so that the TiO₂ layer was formed thereon. The TiO₂ layer underwent pretreatment and then the second Ti treatment in the following manner. The TiO₂ layer was dipped in a dispersion of peroxotitanic acid at 70°C for 40 minutes. This dipping was followed by rinsing with pure water to remove a surplus of the Ti-containing solution. After drying, the TiO₂ layer 3 underwent baking at 500°C for 60 minutes.

The TiO₂ layer was allowed to support the sensitizing dye, and then the dye-sensitized solar cell was assembled.

The resulting dye-sensitized solar cell was found to have the characteristic properties as follows.
- Internal resistance R of TiO₂ layer : 62 Ω
- Open-circuit voltage Voc : 0.739 V
- Short-circuit current density Jsc : 14.31 mA/cm²
- Fill factor FF : 62.3%
- Photoelectric conversion efficiency η : 6.59%

### Example 2

The same procedure as in Example 1 was repeated except that the second Ti treatment employed a dispersion of peroxo-modified titanium oxide of anatase type containing particles with an average particle diameter of 3 nm. The description of the procedure is omitted.

The dye-sensitized solar cell according to Example 2 was found to have the characteristic properties as follows.
- Internal resistance R of TiO₂ layer : 58 Ω
- Open-circuit voltage Voc : 0.738 V
- Short-circuit current density Jsc : 14.61 mA/cm²
- Fill factor FF : 66.9%
- Photoelectric conversion efficiency η : 7.21%

### Example 3

The same procedure as in Example 2 was repeated except that the second Ti treatment employed a dispersion of peroxo-modified titanium oxide of anatase type containing particles with an average particle diameter of 5 nm. The description of the procedure is omitted.

The dye-sensitized solar cell according to Example 3 was found to have the characteristic properties as follows.
- Internal resistance R of TiO₂ layer : 50 Ω
- Open-circuit voltage Voc : 0.737 V
- Short-circuit current density Jsc : 14.98 mA/cm²
- Fill factor FF : 67.3%
- Photoelectric conversion efficiency η : 7.43%

### Example 4

The same procedure as in Example 2 was repeated except that the second Ti treatment employed a dispersion of peroxo-modified titanium oxide of anatase type containing particles with an average particle diameter of 10 nm. The description of the procedure is omitted.

The dye-sensitized solar cell according to Example 4 was found to have the characteristic properties as follows.
- Internal resistance R of TiO₂ layer : 44 Ω
- Open-circuit voltage Voc : 0.737 V
- Short-circuit current density Jsc : 15.22 mA/cm²
- Fill factor FF : 67.1%
- Photoelectric conversion efficiency η : 7.53%

### Example 5

The same procedure as in Example 2 was repeated except that the second Ti treatment employed a dispersion of peroxo-modified titanium oxide of anatase type containing particles with an average particle diameter of 40 nm. The description of the procedure is omitted.

The dye-sensitized solar cell according to Example 5 was found to have the characteristic properties as follows.
- Internal resistance R of TiO₂ layer : 44 Ω
- Open-circuit voltage Voc : 0.735 V
- Short-circuit current density Jsc : 15.12 mA/cm²
- Fill factor FF : 67.6%
- Photoelectric conversion efficiency η : 7.51%

### Example 6

The same procedure as in Example 2 was repeated except that the second Ti treatment employed a dispersion of peroxo-modified titanium oxide of anatase type containing particles with an average particle diameter of 50 nm. The description of the procedure is omitted.

The dye-sensitized solar cell according to Example 6 was found to have the characteristic properties as follows.
- Internal resistance R of TiO₂ layer : 46 Ω
- Open-circuit voltage Voc : 0.735 V
- Short-circuit current density Jsc : 1.5.10 mA/cm²
- Fill factor FF : 67.6%
- Photoelectric conversion efficiency η : 7.50%

### Example 7

The same procedure as in Example 2 was repeated except that the second Ti treatment employed a dispersion of peroxo-modified titanium oxide of anatase type containing particles with an average particle diameter of 100 nm. The description of the procedure is omitted.

The dye-sensitized solar cell according to Example 7 was found to have the characteristic properties as follows.
- Internal resistance R of TiO₂ layer : 48 Ω
- Open-circuit voltage Voc : 0.710 V
- Short-circuit current density Jsc : 15.00 mA/cm²
- Fill factor FF : 67.6%
- Photoelectric conversion efficiency η : 7.20%

### Example 8 (for comparison)

The same procedure as in Example 1 was repeated except that the second Ti treatment (or the dipping of the TiO₂ layer) took 120 minutes. The description of the procedure is omitted.

The dye-sensitized solar cell according to Example 8 was found to have the characteristic properties as follows.
- Internal resistance R of TiO₂ layer : 66 Ω
- Open-circuit voltage Voc : 0.736 V
- Short-circuit current density Jsc : 14.81 mA/cm²
- Fill factor FF : 61.6%
- Photoelectric conversion efficiency η : 6.71%

### Example 9

The same procedure as in Example 4 was repeated except that the second Ti treatment (or the dipping of the TiO₂ layer) took 20 minutes. The description of the procedure is omitted.

The dye-sensitized solar cell according to Example 9 was found to have the characteristic properties as follows.
- Internal resistance R of TiO₂ layer : 48 Ω
- Open-circuit voltage Voc : 0.740 V
- Short-circuit current density Jsc : 15.10 mA/cm²
- Fill factor FF : 66.9%
- Photoelectric conversion efficiency η : 7.48%

### Example 10

The same procedure as in Example 4 was repeated except that the second Ti treatment (or the dipping of the TiO₂ layer) took 30 minutes. The description of the procedure is omitted.

The dye-sensitized solar cell according to Example 10 was found to have the characteristic properties as follows.
- Internal resistance R of TiO₂ layer : 46 Ω
- Open-circuit voltage Voc : 0.738 V
- Short-circuit current density Jsc : 15.20 mA/cm²
- Fill factor FF : 67.0%
- Photoelectric conversion efficiency η : 7.52%

### Example 11

The same procedure as in Example 4 was repeated except that the second Ti treatment (or the dipping of the TiO₂ layer) took 60 minutes. The description of the procedure is omitted.

Incidentally, the TiO₂ layer was dipped in a dispersion of peroxo-modified titanium oxide of anatase type at 70°C for 60 minutes, which was followed by rinsing, drying, and baking at 500°C for 60 minutes.

The dye-sensitized solar cell according to Example 11 was found to have the characteristic properties as follows.
- Internal resistance R of TiO₂ layer : 44 Ω
- Open-circuit voltage Voc : 0.735 V
- Short-circuit current density Jsc : 15.31 mA/cm²
- Fill factor FF : 66.6%
- Photoelectric conversion efficiency η : 7.50%

### Example 12

The same procedure as in Example 4 was repeated except that the second Ti treatment (or the dipping of the TiO₂ layer) took 180 minutes. The description of the procedure is omitted.

The dye-sensitized solar cell according to Example 12 was found to have the characteristic properties as follows.
- Internal resistance R of TiO₂ layer : 48 Ω
- Open-circuit voltage Voc : 0.735 V
- Short-circuit current density Jsc : 14.98 mA/cm²
- Fill factor FF : 65.4%
- Photoelectric conversion efficiency η : 7.20%

### Example 13

The same procedure as in Example 4 was repeated except that the second Ti treatment (or the dipping of the TiO₂ layer) was carried out at 25°C. The description of the procedure is omitted.

The dye-sensitized solar cell according to Example 13 was found to have the characteristic properties as follows.
- Internal resistance R of TiO₂ layer : 62 Ω
- Open-circuit voltage Voc : 0.736 V
- Short-circuit current density Jsc : 14.50 mA/cm²
- Fill factor FF : 62.0%
- Photoelectric conversion efficiency η : 6.62%

### Example 14

The same procedure as in Example 4 was repeated except that the second Ti treatment (or the dipping of the TiO₂ layer) was carried out at 50°C. The description of the procedure is omitted.

The dye-sensitized solar cell according to Example 14 was found to have the characteristic properties as follows.
- Internal resistance R of TiO₂ layer : 48 Ω
- Open-circuit voltage Voc : 0.735 V
- Short-circuit current density Jsc : 15.00 mA/cm²
- Fill factor FF : 67.4%
- Photoelectric conversion efficiency η : 7.43%

### Example 15

The same procedure as in Example 4 was repeated except that the second Ti treatment (or the dipping of the TiO₂ layer) was carried out at 90°C. The description of the procedure is omitted.

The dye-sensitized solar cell according to Example 15 was found to have the characteristic properties as follows.
- Internal resistance R of TiO₂ layer : 50 Ω
- Open-circuit voltage Voc : 0.730 V
- Short-circuit current density Jsc : 15.20 mA/cm²
- Fill factor FF : 67.4%
- Photoelectric conversion efficiency η : 7.48%

### Example 16 (for comparison)

The same procedure as in Example 4 was repeated except that the second Ti treatment employed an aqueous solution of TiCl₄. The description of the procedure is omitted.

The dye-sensitized solar cell according to Example 16 was found to have the characteristic properties as follows.
- Internal resistance R of TiO₂ layer : 51 Ω
- Open-circuit voltage Voc : 0.731 V
- Short-circuit current density Jsc : 15.68 mA/cm²
- Fill factor FF : 63.6%
- Photoelectric conversion efficiency η : 7.29%

### Example 17 (for comparison)

The same procedure as in Examples 1 to 15 was repeated except that the second Ti treatment was not carried out. The description of the procedure is omitted.

The dye-sensitized solar cell according to Example 17 was found to have the characteristic properties as follows.
- Internal resistance R of TiO₂ layer : 70 Ω
- Open-circuit voltage Voc : 0.744 V
- Short-circuit current density Jsc : 14.21 mA/cm²
- Fill factor FF : 60.4%
- Photoelectric conversion efficiency η : 6.39%

### Example 18 (for comparison)

The same procedure as in Example 16 was repeated except that the first Ti treatment was not carried out. The description of the procedure is omitted.

The dye-sensitized solar cell according to Example 18 was found to have the characteristic properties as follows.
- Internal resistance R of TiO₂ layer : 80 Ω
- Open-circuit voltage Voc : 0.738 V
- Short-circuit current density Jsc : 13.81 mA/cm²
- Fill factor FF : 59.0%
- Photoelectric conversion efficiency η : 6.01%

### Example 19 (for comparison)

The same procedure as in Example 16 was repeated except that the first Ti treatment employed an aqueous solution of TiCl₄. The description of the procedure is omitted.

The dye-sensitized solar cell according to Example 19 was found to have the characteristic properties as follows.
- Internal resistance R of TiO₂ layer : 51 Ω
- Open-circuit voltage Voc : 0.731 V
- Short-circuit current density Jsc : 15.65 mA/cm²
- Fill factor FF : 63.5%
- Photoelectric conversion efficiency η : 7.26%

### Example 20 (for comparison)

The same procedure as in Example 19 was repeated except that the first Ti treatment was not carried out. The description of the procedure is omitted.

The dye-sensitized solar cell according to Example 19 was found to have the characteristic properties as follows.
- Internal resistance R of TiO₂ layer : 72 Ω
- Open-circuit voltage Voc : 0.744 V
- Short-circuit current density Jsc : 14.31 mA/cm²
- Fill factor FF : 59.6%
- Photoelectric conversion efficiency η : 6.35%

### Example 21

The same procedure as in Example 4 was repeated except that the first Ti treatment employed an aqueous solution of TiCl₄. The description of the procedure is omitted.

The dye-sensitized solar cell according to Example 21 was found to have the characteristic properties as follows.
- Internal resistance R of TiO₂ layer : 46 Ω
- Open-circuit voltage Voc : 0.737 V
- Short-circuit current density Jsc : 15.32 mA/cm²
- Fill factor FF : 66.2%
- Photoelectric conversion efficiency η : 7.48%

### [Characteristics of the dye-sensitized solar cell]

The dye-sensitized solar cells produced in Examples 1 to 21 mentioned above were examined for their characteristic properties listed below by irradiation with artificial sunlight (AM 1.5, 100 mw/cm²) . Current-voltage curve (I-V characteristics), short-circuit current Isc, open-circuit voltage Voc, fill factor FF, internal resistance (serial resistance) R, and photoelectric conversion efficiency η.

The short-circuit current Isc is a current which flows through a conductor short-circuiting the anode and cathode of the solar cell. It is represented in terms of short-circuit current density Jsc per unit area of the solar cell. The open-circuit voltage Voc is a voltage that appears across the anode and cathode of the solar cell which are not connected to anything.

The fill factor FF (which is also called form factor) is one the parameters to specify the characteristics of the solar cell. An ideal solar cell gives a current-voltage curve in which the output voltage (equal to the open-circuit voltage Voc) remains constant until the output current reaches the same magnitude as the short-circuit current Isc. However, an actual solar cell gives a current-voltage curve which deviates from an ideal one on account of the internal resistance. The fill factor FF is defined by the ratio of A/B, where A denotes the area of the region surrounded by the actual current-voltage curve and the x axis and y axis, and B denotes the area of the region surrounded by the ideal current-voltage curve and the x axis and y axis. In other words, the fill factor FF indicates the degree of deviation from the ideal current-voltage curve. It is used to calculate the actual photoelectric conversion efficiency η.

The fill factor FF is defined by (Vmax·Tmax)/(Voc·Isc), where Vmax and Imax denote respectively the voltage and current at the operating point for the maximum output power. The photoelectric conversion efficiency η is defined by Voc·Jsc·FF, where Jsc denotes the short-circuit current density obtained by dividing the short-circuit current Isc by the effective light-receiving area.

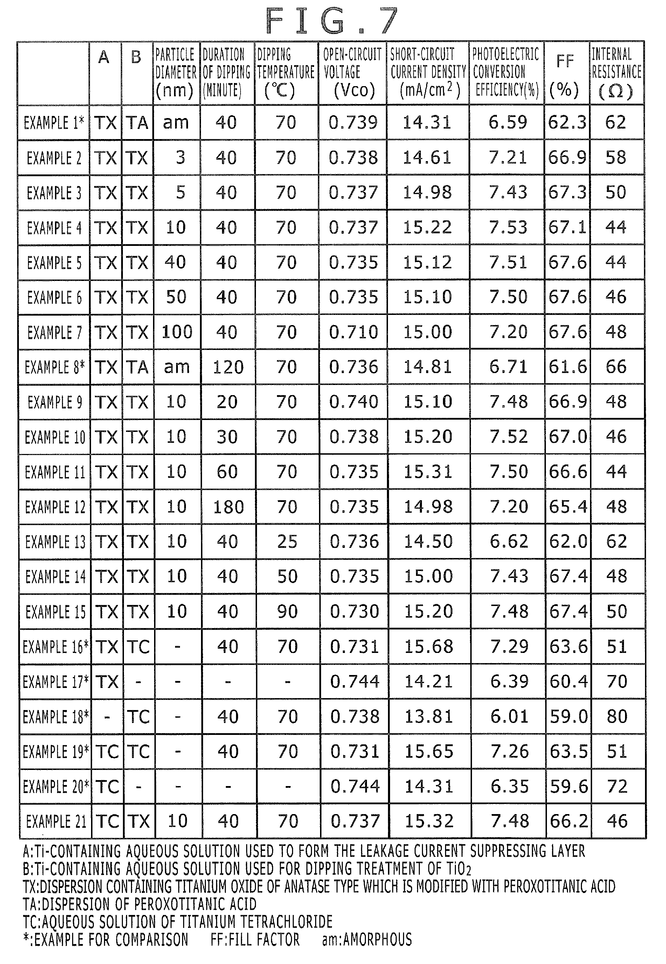

The dye-sensitized solar cells in the foregoing examples have the differently formed porous titanium dioxide layers and the characteristic properties as shown in Fig. 7.

In Fig 7, FF represents fill factor (%) , am implies that the peroxotitanic acid is amorphous one, and * denotes a comparative example. The dipping temperature is a temperature at which the porous titanium dioxide is dipped in a dispersion of peroxotitanic acid (TA), a dispersion of peroxo-modified titanium oxide of anatase type (TX), or an aqueous solution of titanium tetrachloride (TC). The internal resistance (Ω) is a serial resistance in the dye-sensitized solar cell.

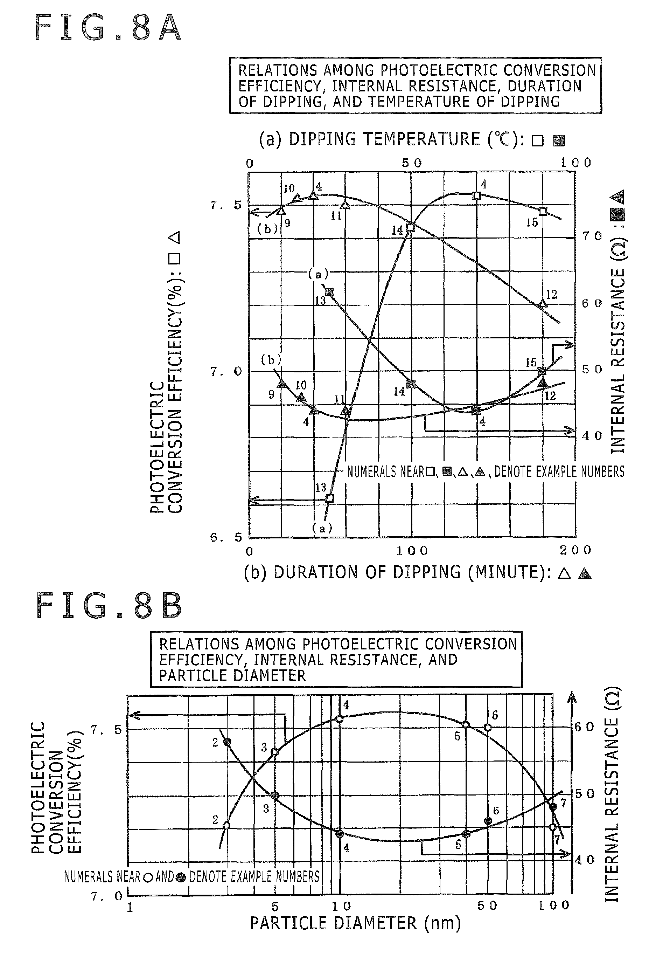

Figs. 8A and 8B are diagrams illustrating relations between the method for forming the porous titanium dioxide layer and the characteristic properties of the dye-sensitized solar cell pertaining to the embodiment of the present disclosure. In Fig. 8A, the photoelectric conversion efficiency (%) and the internal resistance (Ω) are plotted against the dipping temperature (°C) and the dipping time (minutes). In Fig. 8B, the photoelectric conversion efficiency (%) and the internal resistance (Ω) are plotted against the average particle diameter (nm) of the particles of peroxo-modified titanium oxide of anatase type.

Fig. 8A contains two curves (a) for Examples 4 and 13 to 15, and two curves (b) for Examples 4 and 9 to 12. The curves (a) represent the photoelectric conversion efficiency and internal resistance which are plotted against the dipping temperature which was varied, with the dipping time kept constant at 40 minutes. The curves (b) represent the photoelectric conversion efficiency and internal resistance which are plotted against the dipping time which was varied, with the dipping temperature kept constant at 70°C. All of these examples employed the dispersion of peroxo-modified titanium oxide of anatase type which contains particles with an average particle diameter of 10 nm.

The curve (a) suggests that the photoelectric conversion efficiency steeply increases as the dipping temperature increases above 25°C, reaches the maximum at the dipping temperature of 70°C, and gradually decreases with the further increasing dipping temperature. It is noted that the photoelectric conversion efficiency is higher than 7.4% at the dipping temperatures ranging from 50°C to 90°C.

The curve (a) also suggests that the internal resistance steeply decreases as the dipping temperature increases above 25°C, reaches the minimum at the dipping temperature of 70°C, and steeply rises with the further increasing dipping temperature. It is noted that the internal resistance is lower than 50 Ω at the dipping temperatures ranging from 50°C to 90°C.

Incidentally, the dipping temperature above 90°C may not be practical because the dispersion of peroxo-modified titanium oxide of anatase type tends to dry at such a high dipping temperature.

The curve (b) suggests that the photoelectric conversion efficiency gradually increases as the dipping time increases from 20 minutes, reaches the maximum at the dipping time of 60 minutes, and gradually decreases with the further increasing dipping time. It is noted that the photoelectric conversion efficiency is higher than 7.5% at the dipping time ranging from 20 to 80 minutes.

The curve (b) also suggests that the internal resistance gradually decreases as the dipping time increases from 20 minutes, reaches the minimum at the dipping time of about 60 minutes, and gradually increases with the further increasing dipping time. It is noted that the internal resistance is lower than 45 Ω at the dipping time ranging from 40 to 140 minutes, and that photoelectric conversion efficiency gradually increases at the dipping time ranging from 20 to 160 minutes and decreases at the dipping time as long as 180 minutes.

Fig. 8B is a diagram showing how the solar cell in Examples 2 to 7 vary in photoelectric conversion efficiency and internal resistance depending on the average particle diameter of the particles contained in the dispersion of peroxo-modified titanium oxide of anatase type when the dispersion was applied by dipping at 70°C for 70 minutes.

It is noted from Fig. 8B that the photoelectric conversion efficiency varies depending on the average particle diameter of particles contained in the dispersion of peroxo-modified titanium oxide of anatase type. It increases, reaches the maximum, and decreases as the average particle diameter exceeds 3 nm, reaches 20 nm, and becomes larger, respectively.

The photoelectric conversion efficiency is higher than 7.2%, higher than 7.4%, and higher than 7.5% when the average particle diameter of particles in the dispersion of peroxo-modified titanium oxide of anatase type is in the range of 3 to 100 nm, 5 to 60 nm, and 10 to 40 nm, respectively.

Moreover, the internal resistance decreases, reaches the minimum, and increases as the average particle diameter of particles in the dispersion of peroxo-modified titanium oxide of anatase type exceeds 3 nm, reaches 20 nm, and becomes larger, respectively.

The internal resistance is lower than 50 Ω and lower than 45 Ω when the average particle diameter of particles in the dispersion of peroxo-modified titanium oxide of anatase type is in the range of 5 to 60 nm and 10 to 40 nm, respectively.

Fig. 8B suggests that the photoelectric conversion efficiency can be maximized if the average particle diameter of particles in the dispersion of peroxo-modified titanium oxide of anatase type is controlled so that the internal resistance is minimized.

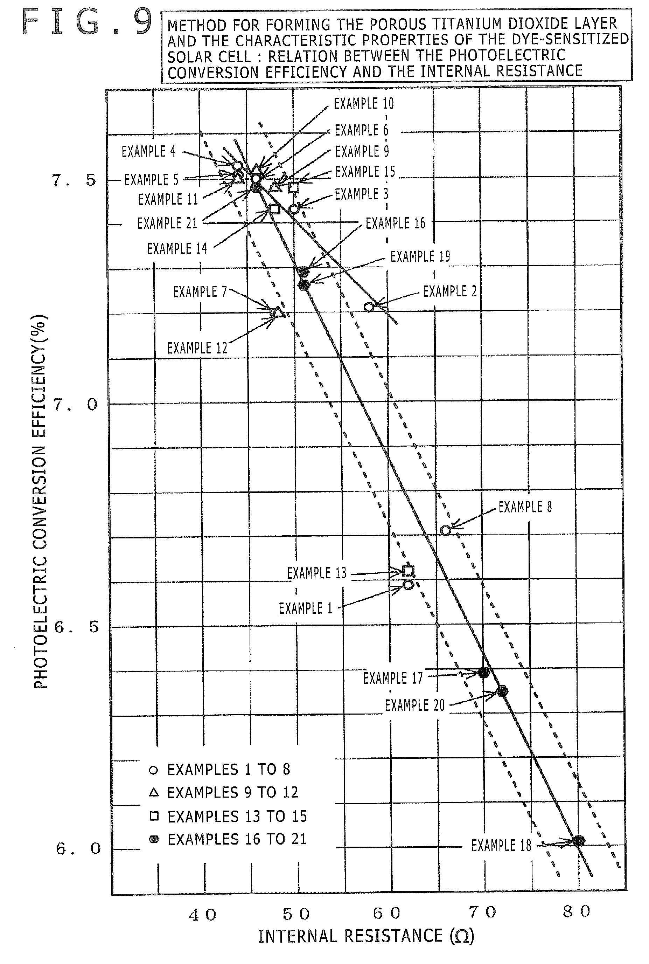

Fig. 9 is a diagram illustrating how the dye-sensitized solar cell according to the present embodiment varies in characteristic properties depending on the method of forming the porous titanium dioxide layer. In other words, it is a diagram illustrating the relation between photoelectric conversion efficiency and the internal resistance.

It is noted from Fig. 9 that the dye-sensitized solar cells in Examples 1 to 21 have a correlation between the photoelectric conversion efficiency and the internal resistance, the correlation existing in the region between the two dotted lines. This suggests that the photoelectric conversion efficiency is largely affected by the internal resistance.

It is also noted from Fig. 9 that the correlation between the photoelectric conversion efficiency and the internal resistance distributes along the dotted straight lines, except for Examples 1, 7, 8, 12, 13 and 16 to 21. Incidentally, Examples 1 and 8 differ from other examples in that they employed a dispersion of peroxotitanic acid in the second Ti treatment; Example 7 differs from other examples in that it employed a dispersion of peroxo-modified titanium oxide of anatase type which contains particles having an average particle diameter of 100 nm; Example 12 differs from other examples in that it employed the second Ti treatment in which the duration of dipping was 18 minutes; and Example 13 differs from other example in that it employed the second Ti treatment in which the dipping temperature was 25°C.

It is noted from Figs. 7 to 9 that Examples 7 and 12 achieved almost the same performance with a low internal resistance. A probable reason for the low photoelectric conversion efficiency in Example 7 is that the dispersion of peroxo-modified titanium oxide of anatase type contains particles having a large average particle diameter and hence the eventually obtained porous titanium oxide layer has a low specific surface area, which leads to a small amount of the dye adsorbed to the titanium dioxide layer.

Similarly, a probable reason the low photoelectric conversion efficiency in Example 12 is that the titanium dioxide layer was dipped in the dispersion of peroxo-modified titanium oxide of anatase type at 70°C for 180 minutes and this extended duration of dipping caused the particles (having a diameter of 10 nm) in the dispersion to grow to such an extent that the eventually obtained porous titanium oxide layer has a low specific surface area, which leads to a small amount of the dye adsorbed to the titanium dioxide layer.

As shown in Figs. 7 to 9, Example 13 does not achieve a high photoelectric conversion efficiency (as in Example 1) probably because the titanium dioxide layer was dipped in the dispersion of peroxo-modified titanium oxide of anatase type which was at 25°C. Dipping at this low temperature does not sufficiently promote reaction between the titanium dioxide particles constituting the titanium dioxide layer and the particles contained the dispersion, which makes the titanium dioxide layer low in conductivity and does not permit the eventually obtained porous titanium dioxide layer to decrease in internal resistance.

As mentioned above, Example 1 differs from other examples in that the titanium dioxide layer was dipped in a dispersion of peroxotitanic acid not containing crystalline particles of anatase type. This is a probable reason why the titanium dioxide layer does not sufficiently improve in conductivity and the eventually obtained porous titanium dioxide layer does not decrease in internal resistance and the resulting solar cell is poor in photoelectric conversion efficiency.

As mentioned above, Example 8 differs from Example 1 in that the duration of dipping in the dispersion of peroxotitanic acid was extended to 120 minutes (three times longer). This extended duration of dipping resulted in an increased internal resistance from 62 Ω to 66 Ω and an increased photoelectric conversion efficiency from 6.59% to 6.71% as shown in Figs. 7 and 9. However, the effect of extending the duration of dipping is not so significant.

It is noted from Fig. 7 that Example 4 is lower in short-circuit current density but better in photoelectric conversion efficiency than Example 16 because Example 4 is higher in open-circuit voltage and fill factor FF and lower in internal resistance than Example 16.

As shown in Figs. 7 and 9, Examples 16 and 19 are almost the same in photoelectric conversion efficiency regardless of the kind of the Ti-containing aqueous solution used for the first Ti treatment although they employed a TiCl₄ aqueous solution for the second Ti treatment.

Also, as shown in Figs. 7 and 9, Examples 17 and 19 are almost the same in photoelectric conversion efficiency regardless of the kind of the Ti-containing aqueous solution used for the first Ti treatment although they do not involve the second Ti treatment.

Examples 19 to 21 employed an aqueous solution of TiCl₄ for the first Ti treatment but they differ from one another in that the Ti-containing aqueous solution for the second Ti treatment is an aqueous solution of titanium tetrachloride (in Example 19), is not used (in Example 20), and is a dispersion of peroxo-modified titanium oxide of anatase type. As the result, Example 21 which employed a dispersion of peroxo-modified titanium oxide of anatase type achieved the highest photoelectric conversion efficiency.

As shown in Figs. 7 and 9, the photoelectric conversion efficiency was almost the same (7.4% to 7.5%) in Examples 3 to 6, 9 to 11, 13, 15, and 21, which employed a dispersion of peroxo-modified titanium oxide of anatase type for the second Ti treatment.

As mentioned above, it was found that an effective way to improve the photoelectric conversion efficiency is to use a dispersion of peroxo-modified titanium oxide of anatase type for the second Ti treatment.

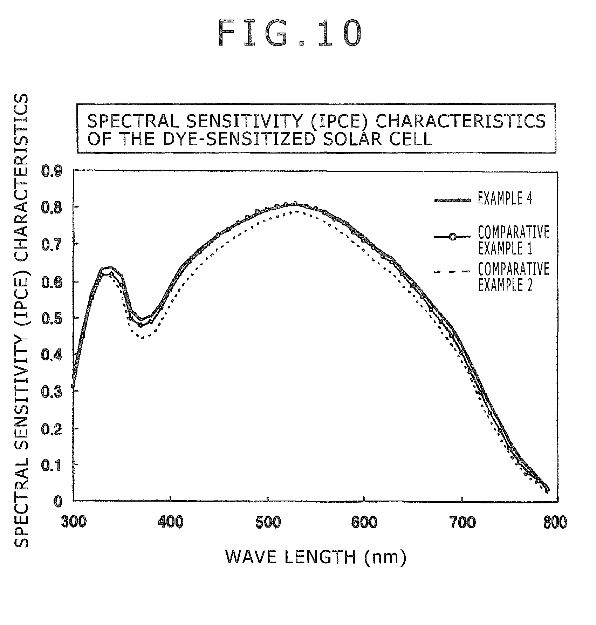

Fig. 10 is a diagram showing the spectral sensitivity (IPCE) of the dye-sensitized solar cell according to this embodiment. The abscissa represents the wavelength (nm), and the ordinate represents the spectral sensitivity (IPCE).

Fig. 10 is a diagram illustrating the results of the measurements of the IPCE characteristics of the samples in Examples 4, 16, and 17. It is noted that Examples 4 and 16 gave almost the same IPCE characteristics and Example 4 gave more improved IPCE characteristics than Example 17.

As mentioned above, the dye-sensitized solar cell according to this embodiment has improved IPCE characteristics and hence a high photoelectric conversion efficiency because it is provided with the titanium dioxide layer which is prepared by dipping in a dispersion of peroxo-modified titanium oxide of anatase type containing particles with a controlled average particle diameter, the dipping being followed by drying and baking.

### Example 22

### [Preparation of transparent conductive substrate]

The transparent conductive substrate was prepared by forming an FTO layer (with a thickness of 1000 nm and a sheet resistance of 10 Ω/□) on the surface of a glass substrate by CVD process.

### [Formation of leakage current suppressing layer]

First, the FTO layer on the transparent conductive substrate underwent surface treatment with UV/ozone. The surface of the FTO layer was coated twice by spin coating with a dispersion of amorphous peroxotitanic acid (which is a dispersion of amorphous peroxotitanic acid in water), commercially available from Kon Corporation under a tradename of Sagancoat PTX-sol) . Spin coating was carried out at 1000 rpm for 40 seconds. Spin coating was followed by aging at 70°C for 10 minutes in a thermostat, so that the coating film of the dispersion of amorphous peroxotitanic acid was dried and fixed. In this way there was formed the TiO₂ layer which functions as the leakage current suppressing layer.

### [Isolation of spindle-shaped particles of peroxo-modified titanium oxide of anatase type]

"Sagancoat PTX-sol" from Kon Corporation (which is a dispersion of peroxo-modified titanium oxide of anatase type) was evaporated to dryness at 40°C. Thus there were isolated particles of peroxo-modified titanium oxide of anatase type in the form of yellowish powder.

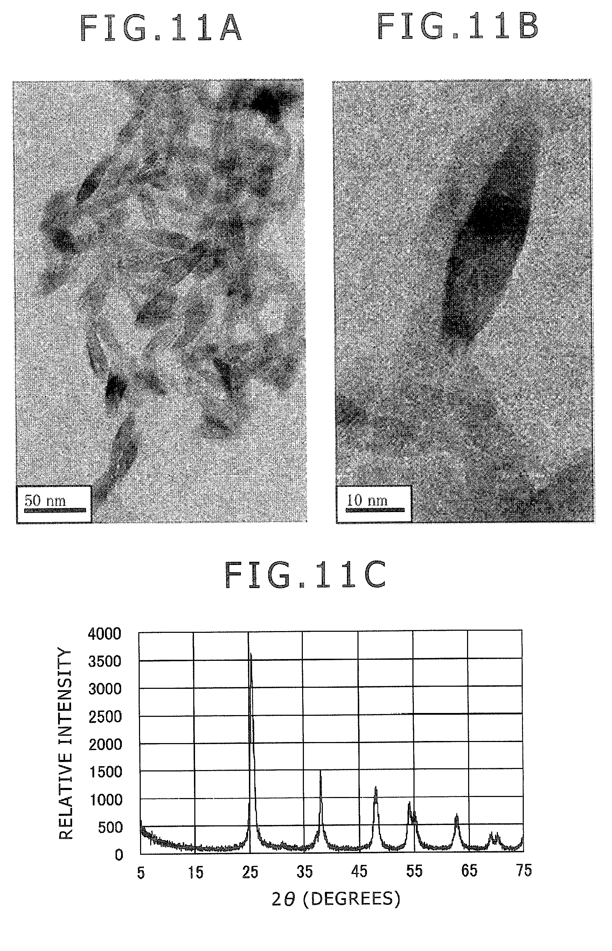

The thus obtained yellowish powder was photographed by means of a TEM. The resulting micrographs are shown in Figs. 11A and 11B. It is noted from Figs. 11A and 11B that the yellowish powder consists of spindle-shaped particles each having a long axis of 50 nm and a short axis of 10 nm.

The yellowish powder was also tested for X-ray diffraction (XRD) by using an X-ray diffraction apparatus (PINT TTRII made by Rigaku Corporation), which was operated at an accelerating voltage of 50 kV and a current of 300 mA, with a copper target. The resulting X-ray diffraction pattern, which has peaks attributable to anatase, is shown in Fig. 11C.

### [Preparation of modified titanium oxide paste]

The isolated powder of spindle-shaped particles of peroxo-modified titanium oxide of anatase type was added to 50 g of commercial titanium oxide paste ("PST-24RNT" made by Catalysts & Chemicals Industries Co., Ltd) such that the former accounts for 5 wt% based on the latter in terms of TiO₂. They were mixed together by using a mixer ("Awatori Neritaro ARE-310" made by Shinky). The resulting mixture was passed through a three-roll mill for complete dispersion. In this way there was obtained a paste of modified titanium oxide.

### [Formation of TiO₂ layer]

The paste of modified titanium oxide was applied to the leakage current suppressing layer on the transparent conductive substrate by screen paste method, so that there was formed a layer of fine particles which has a round shape (5 mm in diameter) and a thickness of 12 µm. This step was followed by baking at 500°C for 60 minutes. Thus there was formed the TiO₂ layer on the leakage current suppressing layer.

### [Step for the sensitizing dye to be supported on TiO₂ layer]

First, Z907 and DPA (in a molar ratio of 4:1) were dissolved in a 1:1 mixed solvent of tert-butanol and acetonitrile (by volume). Z907 is a sensitizing dye having a chemical name of cis-bis(isothiocyanate)-(2,2'-bipyridine-4,4'-carboxylate)-(2,2'-bipyridine-4,4'-dinonyl)ruthenium (II). DPA is a coadsorbing agent having a chemical name of 1-decylphosphonic acid.

The TiO₂ layer was dipped in the solution of mixed solvent at room temperature for 24 hours, so that the sensitizing dye was adsorbed and supported on the surface of TiO₂ fine particles of the TiO₂ layer. Then, the TiO₂ layer was washed with acetonitrile and the solvent was evaporated for drying in a dark place. Thus there was obtained the TiO₂ layer which supports the sensitizing dye Z907.

### [Formation of the counter substrate]

A glass substrate was coated with an FTO layer (with a thickness of 1000 nm and a sheet resistance of 10 Ω/□) by CVD process, so that the transparent conductive substrate was formed. The FTO layer on the transparent conductive substrate was sequentially coated with a chromium layer (500 Å thick) and a platinum layer (1000 Å thick) by sputtering. These layers function as the counter electrode. An inlet (0.5 mm in diameter) for the electrolyte solution to be injected was made in the counter electrode.

### [Assembling of the dye-sensitized solar cell]

The TiO₂ layer which supports the sensitizing dye Z907 was arranged opposite to the counter electrode, and their periphery was sealed with an ionomer resin film (30 µm thick) and UV curable acrylic resin. The space between the TiO₂ layer and the counter electrode was filled with an electrolyte solution composed of LiI (0.05 mol/L), methoxypropioimidazolium iodide (1.0 mol/L), iodine (0.10 mol/L), and 1-butylbenzimidazole (NBB) (0.25 mol/L), which was injected through the inlet. After evacuation to remove bubbles, the inlet was sealed with an ionomer resin film and acrylic resin. Thus, there was completed the dye-sensitized solar cell as desired.

### Example 23

The same procedure as in Example 22 was repeated to produce the dye-sensitized solar cell except that the isolated powder of spindle-shaped particles of peroxo-modified titanium oxide of anatase type was added to 50 g of commercial titanium oxide paste ("PST-24RNT" made by Catalysts & Chemicals Industries Co., Ltd) such that the former accounts for 9 wt% based on the latter in terms of TiO₂.

### Example 24

The same procedure as in Example 22 was repeated to produce the dye-sensitized solar cell except that the isolated powder of spindle-shaped particles of peroxo-modified titanium oxide of anatase type was added to 50 g of commercial titanium oxide paste ("PST-24RNT" made by Catalysts & Chemicals Industries Co., Ltd) such that the former accounts for 18 wt% based on the latter in terms of TiO₂.

### Example 25 (for comparison)

The same procedure as in Example 22 was repeated to produce the dye-sensitized solar cell except that the commercial titanium oxide paste ("PST-24RNT" made by Catalysts & Chemicals Industries Co., Ltd) was used alone (without incorporation with the isolated powder of spindle-shaped particles of peroxo-modified titanium oxide of anatase type).

### Example 26

The same procedure as in Example 23 was repeated to produce the dye-sensitized solar cell except that the powder of spindle-shaped particles of peroxo-modified titanium oxide of anatase type which was added to a titanium oxide paste such that the former accounts for 9 wt% based on the latter in terms of TiO₂ was replaced by the powder of spherical particles of peroxo-modified titanium oxide of anatase type which was isolated in the following way.

### [Isolation of spherical particles of peroxo-modified titanium oxide of anatase type]

First, titanium isopropoxide (5.5 g) was dissolved in isopropanol (15 g). After cooling in an ice bath, the resulting solution was given dropwise 10% hydrogen peroxide (10 mL). This step was followed by stirring for two hours with cooling in a water bath, stirring for five hours at room temperature, and stirring at 60°C for 24 hours. The aged solution underwent hydrothermal treatment at 150°C for one hour in a heat-resistant autoclave to give a dispersion containing peroxo-modified titanium oxide of anatase type. This solution was allowed to evaporate to dryness. Thus there was obtained a yellowish powder.

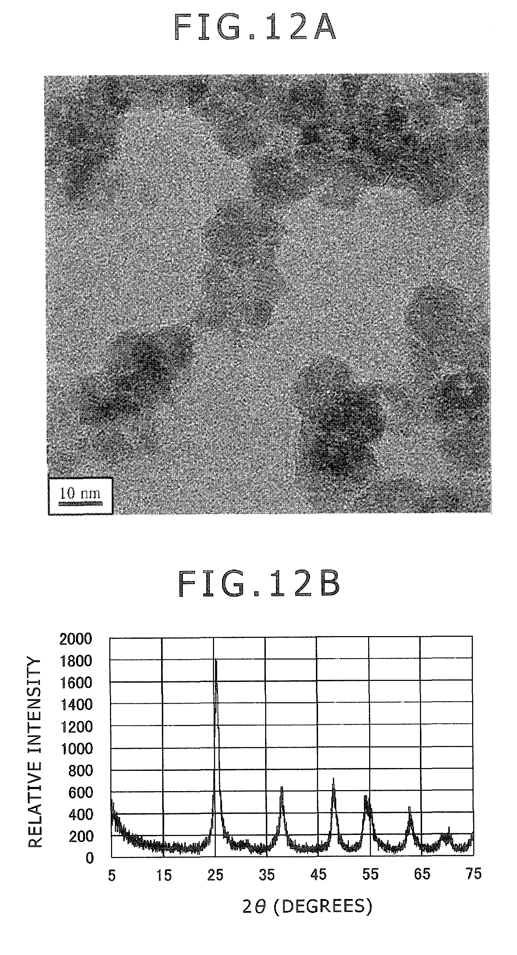

The thus obtained yellowish powder was photographed by means of a TEM. The resulting micrograph is shown in Fig. 12A. It is noted from Fig. 12A that the yellowish powder consists of almost spherical particles and has diameter of about 10 nm.

The yellowish powder was also tested for X-ray diffraction (XRD) under the same conditions as in Example 22. The results are shown in Fig. 12B. It is noted that the resulting X-ray diffraction pattern has peaks attributable to anatase.

### Example 27

The same procedure as in Example 26 was repeated to produce the dye-sensitized solar cell except that the isolated powder of spherical particles of peroxo-modified titanium oxide of anatase type was added to 50 g of commercial titanium oxide paste ("PST-24RNT" made by Catalysts & Chemicals Industries Co., Ltd) such that the former accounts for 18 wt% based on the latter in terms of TiO₂.

### Example 28 (for comparison)

The same procedure as in Example 22 was repeated to produce the dye-sensitized solar cell except that the powder of spindle-shaped particles of peroxo-modified titanium oxide of anatase type (which was added to a titanium oxide paste such that the former accounts for 5 wt% based on the latter in terms of TiO₂) was replaced by the powder of amorphous particles of peroxo-modified titanium oxide of anatase type which was isolated in the following way.

### [Isolation of amorphous particles of peroxo-modified titanium oxide]

First, titanium isopropoxide (5.5 g) was dissolved in isopropyl alcohol (15 g). After cooling in an ice bath, the resulting solution was given dropwise 10% hydrogen peroxide (10 mL). This step was followed by stirring for two hours with cooling in a water bath, stirring for five hours at room temperature, and stirring at 60°C for 24 hours. Thus there was obtained a dispersion of amorphous peroxotitanic acid. This dispersion was allowed to evaporate to dryness. Thus there was obtained a yellowish powder of amorphous peroxotitanic acid.

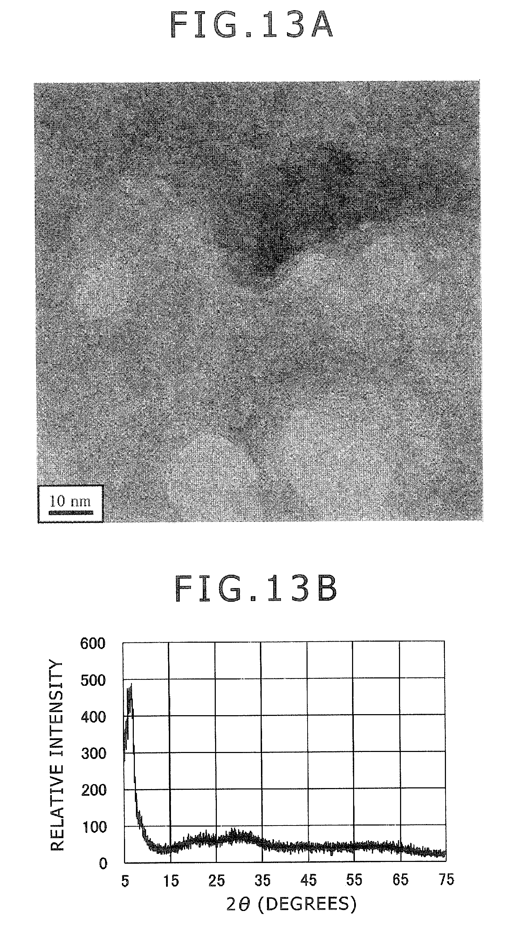

The thus obtained yellowish powder was photographed by means of a TEM. The resulting micrograph is shown in Fig. 13A. It is noted from Fig. 13A that the yellowish powder consists of amorphous particles.

The yellowish powder was also tested for X-ray diffraction (XRD) under the same conditions as in Example 22. The results are shown in Fig. 13B. The resulting X-ray diffraction pattern indicates that the yellowish powder consists of amorphous particles.

### Example 29 (for comparison)

The same procedure as in Example 28 was repeated to produce the dye-sensitized solar cell except that the isolated powder of amorphous particles of peroxotitanic acid was added to 50 g of commercial titanium oxide paste ("PST-24RNT" made by Catalysts & Chemicals Industries Co., Ltd) such that the former accounts for 9 wt% based on the latter in terms of TiO₂.

### Example 30 (for comparison)

The same procedure as in Example 28 was repeated to produce the dye-sensitized solar cell except that the isolated powder of amorphous particles of peroxotitanic acid was added to 50 g of commercial titanium oxide paste ("PST-24RNT" made by Catalysts & Chemicals Industries Co., Ltd) such that the former accounts for 18 wt% based on the latter in terms of TiO₂.

### Example 31 (for comparison)

The same procedure as in Example 23 was repeated to produce the dye-sensitized solar cell except that the powder of spindle-shaped particles of peroxo-modified titanium oxide of anatase type (which was added to a titanium oxide paste such that the former accounts for 9 wt% based on the latter in terms of TiO₂) was replaced by the powder of spindle-shaped particles of titanium oxide of anatase type which was isolated in the following way.

### [Isolation of spindle-shaped particles of titanium oxide of anatase type]

"Sagancoat TO-sol" from Kon Corporation (which is a dispersion of titanium oxide of anatase type) was evaporated to dryness at 40°C. Thus there were isolated spindle-shaped particles of titanium oxide of anatase type in the form of whitish powder.

### Example 32 (for comparison)

The same procedure as in Example 31 was repeated to produce the dye-sensitized solar cell except that the isolated powder of spindle-shaped particles of titanium oxide was added to 50 g of commercial titanium oxide paste ("PST-24RNT" made by Catalysts & Chemicals Industries Co., Ltd) such that the former accounts for 18 wt% based on the latter in terms of TiO₂.

### [Characteristics of the dye-sensitized solar cell]

The dye-sensitized solar cells produced in Examples 22 to 32 mentioned above were examined for their characteristic properties listed below by irradiation with artificial sunlight (AM 1.5, 100 mW/cm²). Current-voltage curve (I-V characteristics), short-circuit current Isc, open-circuit voltage Voc, fill factor FF, and photoelectric conversion efficiency η.

The short-circuit current Isc is a current which flows through a conductor short-circuiting the anode and cathode of the solar cell. It is represented in terms of short-circuit current density Jsc per unit area of the solar cell. The open-circuit voltage Voc is a voltage that appears across the anode and cathode of the solar cell which are not connected to anything.

The fill factor FF (which is also called form factor) is one of the parameters to specify the characteristics of the solar cell. An ideal solar cell gives a current-voltage curve in which the output voltage (equal to the open-circuit voltage Voc) remains constant until the output current reaches the same magnitude as the short-circuit current Isc. However, an actual solar cell gives a current-voltage curve which deviates from an ideal one on account of the internal resistance. The fill factor FF is defined by the ratio of A/B, where A denotes the area of the region surrounded by the actual current-voltage curve and the x axis and y axis, and B denotes the area of the region surrounded by the ideal current-voltage curve and the x axis and y axis. In other words, the fill factor FF indicates the degree of deviation from the ideal current-voltage curve. It is used to calculate the actual photoelectric conversion efficiency.

The fill factor FF is defined by (Vmax·Imax)/(Voc·Isc), where Vmax and Imax denote respectively the voltage and current at the operating point for the maximum output power. The photoelectric conversion efficiency η is defined by Voc·Jsc·FF, where Jsc denotes the short-circuit current density obtained by dividing the short-circuit current Isc by the effective light-receiving area.

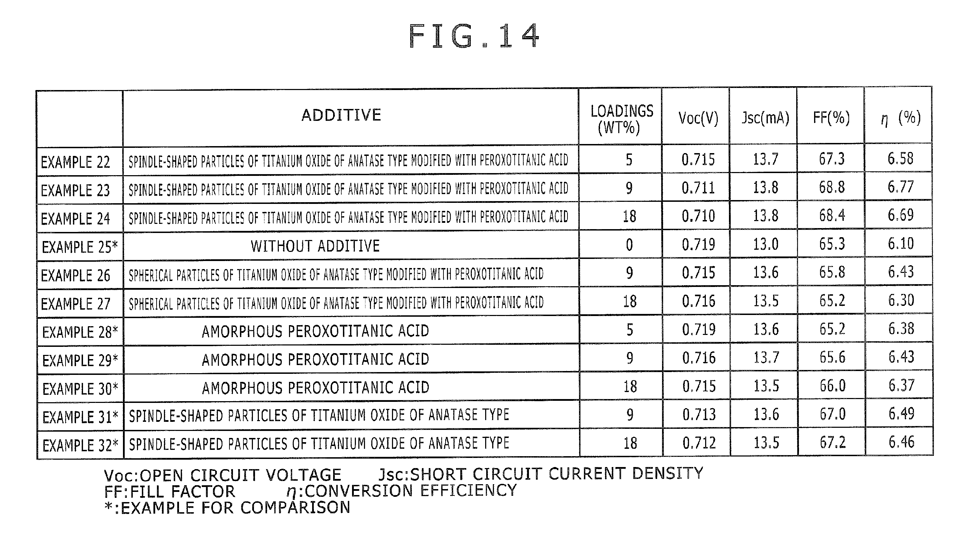

The dye-sensitized solar cells in Examples 22 to 32 were examined for characteristic properties. The results are shown in Fig. 14.

Examples 22 to 24 differ from one another in the loading of the spindle-shaped particles of peroxo-modified titanium oxide of anatase type which was set at 5 wt%, 9 wt%, and 18 wt%, respectively. The conversion efficiency is highest when the loading is 9 wt%. According as the loading increases, the open-circuit voltage Voc decreases, the short-circuit current Jsc remains almost constant, and the fill factor FF increases.

Example 25 has the TiO₂ layer formed without the titanium oxide paste being incorporated with the particles of peroxo-modified titanium oxide of anatase type. Therefore, the solar cell in Example 25 has a higher open-circuit voltage Voc, a lower short-circuit current density Jsc, a lower fill factor FE', and a lower conversion efficiency η than the solar cells in Examples 22 to 24 which employed the spindle-shaped particles of peroxo-modified titanium oxide of anatase type.

Examples 26 and 27 differ from each other in the loading of the spherical particles of peroxo-modified titanium oxide of anatase type which was set at 9 wt% and 18 wt%, respectively. In Examples 26 and 27, the open-circuit voltage Voc is higher but the fill factor FF is lower than in Examples 22 to 24 which employed the spindle-shaped particles of peroxo-modified titanium oxide of anatase type. Moreover, in Examples 26 and 27, the conversion efficiency η is higher than in Example 25, which did not employ the particles of peroxo-modified titanium oxide of anatase type but is lower than in Examples 22 to 24 which employed the spindle-shaped particles of peroxo-modified titanium oxide of anatase type.

Examples 28 to 30 differ from one another in the loading of the amorphous peroxotitanic acid which was set at 5 wt%, 9 wt%, and 18 wt%, respectively. Examples 28 to 30 are almost comparable to Examples 26 and 27, which employed the spherical particles of peroxo-modified titanium oxide of anatase type, in open-circuit voltage Voc, short-circuit current density Jsc, and fill factor FF, and they are superior to Example 25, which did not employ the particles of peroxo-modified titanium oxide of anatase type, but inferior to Examples 22 to 24, which employed the spindle-shaped particles of peroxo-modified titanium oxide of anatase type, in conversion efficiency η. A probable reason why Examples 28 to 30 are almost comparable to Examples 26 and 27 in open-circuit voltage Voc, short-circuit current density Jsc, and fill factor FF is that the baking step in Examples 28 to 30 changes the amorphous peroxotitanic acid into titanium oxide of anatase type.

Examples 31 and 32 differ from each other in the loading of the spindle-shaped titanium oxide of anatase type without modification with peroxotitanic acid which was set at 9 wt% and 18 wt%, respectively. Examples 31 and 32 are inferior in fill factor FF to Examples 22 to 24 which employed the spindle-shaped particles of titanium oxide of anatase type with modification with peroxotitanic acid. A probable reason for this difference in fill factor FF is that the peroxo groups make the particle surface more reactive and hence improve the necking effect in Examples 22 to 24.

Examples 22 to 24, which employed spindle-shaped particles of titanium oxide of anatase type, are superior in conversion efficiency and particularly in fill factor FF to Examples 25, which did not employ titanium oxide, Examples 26 and 27, which employed spherical particles of titanium oxide of anatase type modified with peroxotitanic acid, Examples 28 and 30, which employed amorphous peroxotitanic acid, and Examples 31 and 32, which employed spindle-shaped particles of titanium oxide of anatase type.

The reason why incorporation with spindle-shaped particles of titanium oxide of anatase type modified with peroxotitanic acid improves fill factor FF was ascertained in the following way.

### Example 33

### [Production of sample electrode]

A sample electrode for analysis was prepared in the same way as in Example 23 by sequentially coating the surface of a glass substrate with a leakage current suppressing layer and a TiO₂ layer.

Incidentally, the TiO₂ layer in this sample electrode is one which is formed from titanium oxide paste incorporated with particles of peroxo-modified titanium oxide of anatase type.

### [Observation of the cross section of TiO₂ layer by a TEM]

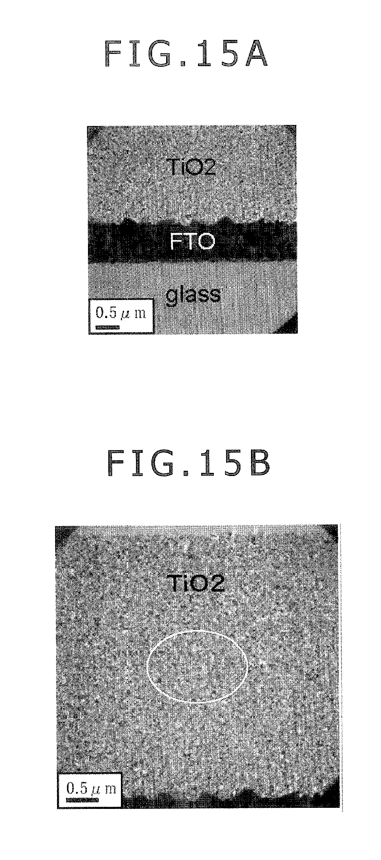

The sample electrode produced as mentioned above was cut by a focused ion beam (FIB) and its cross section was observed by a TEM. Fig. 15A is a TEM micrograph showing the entire cross section of the sample electrode. Fig. 15B is an enlarged TEM micrograph showing a portion of the TiO₂ layer shown in Fig. 15A.

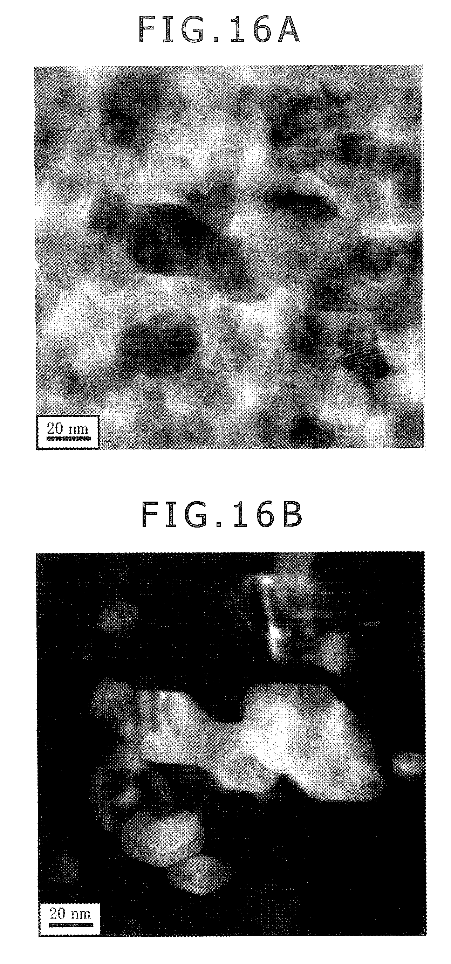

Figs. 16A and 16B are enlarged TEM micrographs showing the encircled portion in Fig. 15B. Fig. 16A is a bright-field micrograph showing the cross section of the TiO₂ layer. Fig. 16B is a high-contrast dark-field micrograph showing the orientation of the spindle-shaped crystal at the center.

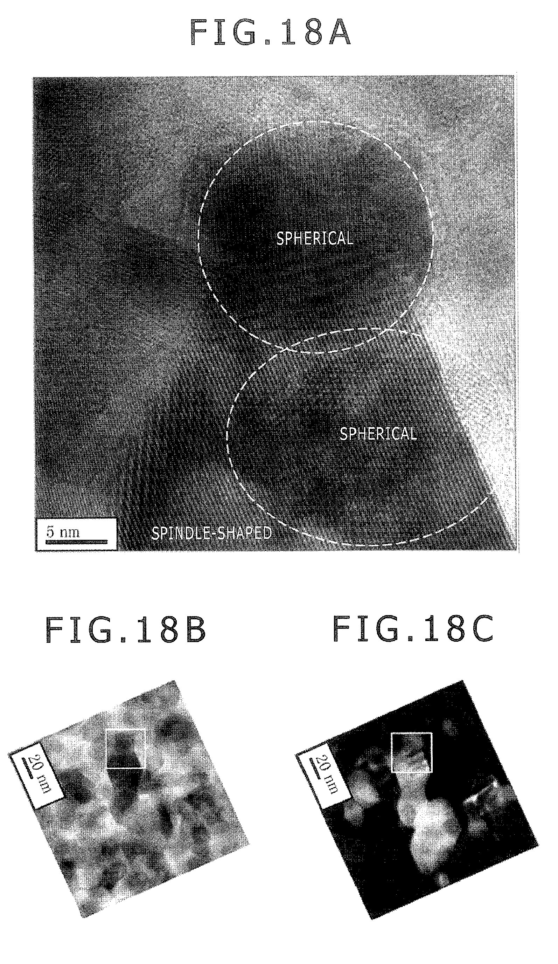

It is noted from Fig. 16A (bright-field micrograph) that the spherical particles of titanium oxide contain spindle-shaped crystals dispersed therein. Fig. 16B (dark-field micrograph) shows white particles of titanium oxide composed of crystals oriented in the same direction as the spindle-shaped particles of titanium oxide at the center. It is considered that the white particles of titanium oxide form strong necking with one another. It is also noted from Fig. 18B that more than one particle of titanium oxide composed of crystals oriented in the same direction constitute a single crystallite.

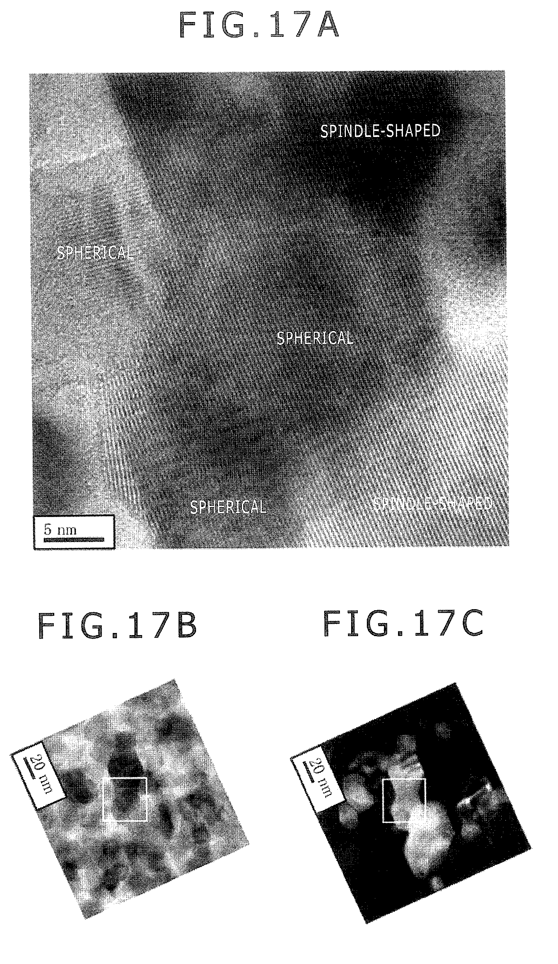

Fig. 17A is an enlarged TEM micrograph showing a certain region in Figs. 16A and 16B. The enlarged portion is indicated by the frame in Fig. 17B (identical with Fig. 16A) and in Fig. 17C (identical with Fig. 16B).

It is noted from Fig. 17A that there is a matched crystal lattice in the interface between the spindle-shaped particle of titanium oxide and the spherical particle of titanium oxide which are joined together by necking. In other words, necking involves a high degree of orientation. It is also noted that the titanium oxide particles constituting the crystallite has a matched crystal lattice in the interface between particles.

Fig. 18A is an enlarged TEM micrograph showing a certain region in Figs. 16A and 16B. The enlarged portion is indicated by the frame in Fig. 18B (identical with Fig. 16A) and in Fig. 18C (identical with Fig. 16B).

It is noted from Fig. 18A that there is a matched crystal lattice in the interface between the spindle-shaped particle of titanium oxide and the spherical particle of titanium oxide which are joined together by necking involving a high degree of orientation.

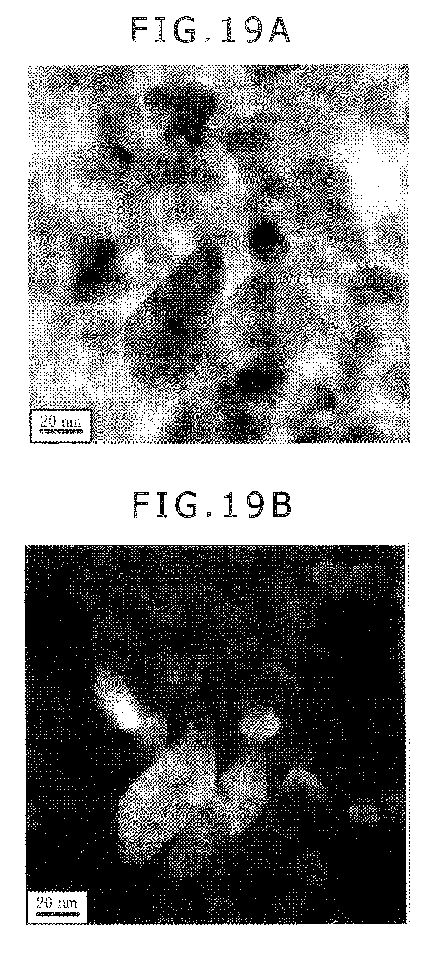

Figs. 19A and 19B are TEM micrographs showing other parts than those shown in Figs. 16A and 16B. Fig. 19A is a bright-field micrograph showing the cross section of the TiO₂ layer. Fig. 19B is a high-contrast dark-field micrograph showing the orientation of the spindle-shaped crystal at the center.

It is noted from the bright-field micrograph shown in Fig. 19A that there are two spindle-shaped crystals in the spherical particle of titanium oxide. It is also noted from the dark-field micrograph shown in Fig. 19B that two spindle-shaped particles of titanium oxide orient in the same direction and they form necking together with surrounding titanium oxide particles.

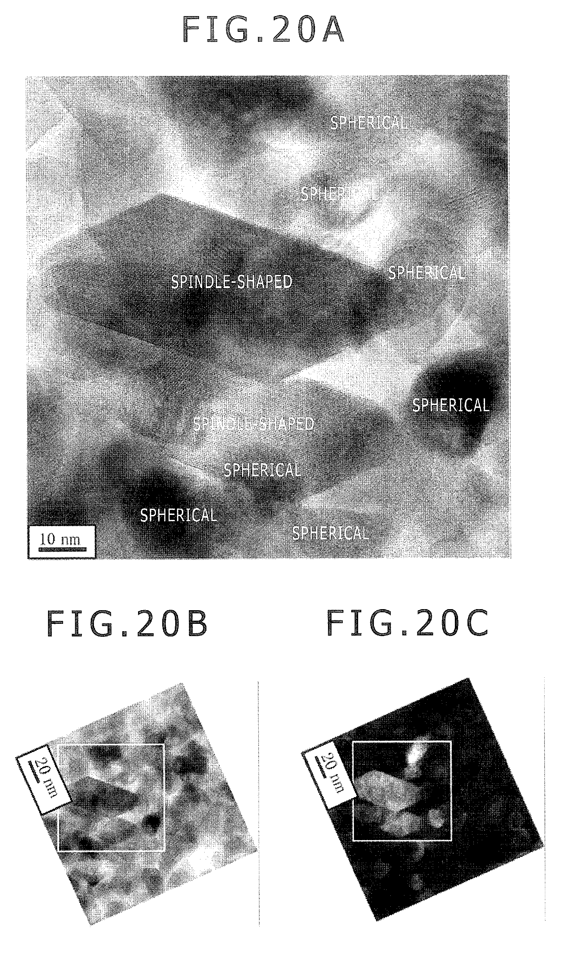

Fig. 20A is an enlarged TEM micrograph showing a certain region in Figs. 19A and 19B. The enlarged portion is indicated by the frame in Fig. 20B (identical with Fig. 19A) and in Fig. 19C (identical with Fig. 19B).

It is noted from Fig. 20A that there is a matched crystal lattice in the interface between the spindle-shaped particle of titanium oxide and the spherical particle of titanium oxide which are joined together by necking involving a high degree of orientation.

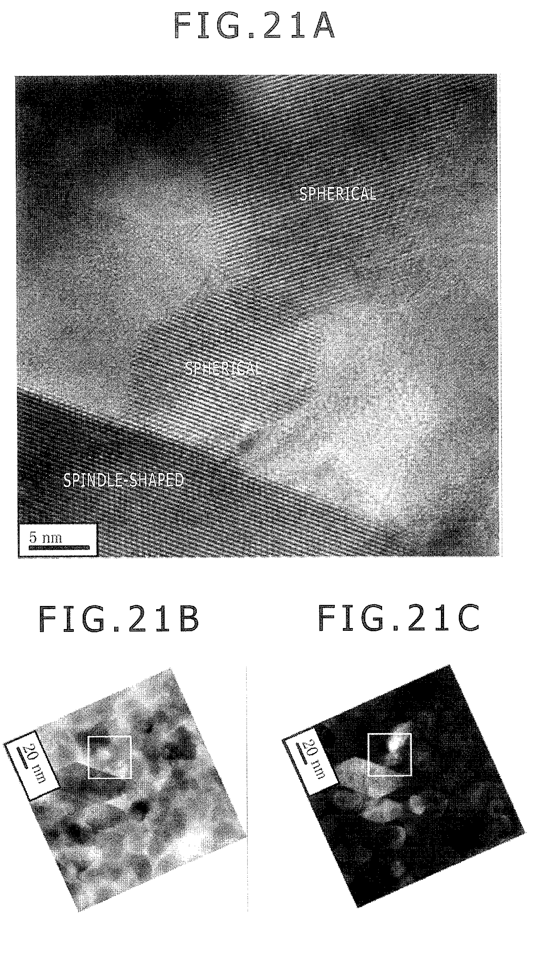

Fig. 21A is an enlarged TEM micrograph showing a certain region in Figs. 19A and 19B. The enlarged portion is indicated by the frame in Fig. 21B (identical with Fig. 19A) and in Fig. 21C (identical with Fig. 19B).

It is noted from Fig. 21A that there is a matched crystal lattice in the interface between the spindle-shaped particle of titanium oxide and the spherical particle of titanium oxide which are joined together by necking involving a high degree of orientation.

### Example 34

### [Production of sample electrode]

A sample electrode for analysis was prepared in the same way as in Example 25 by sequentially coating the surface of a glass substrate with a leakage current suppressing layer and a TiO₂ layer.

Incidentally, the TiO₂ layer in this sample electrode is one which is formed from titanium oxide paste without the particles of peroxo-modified titanium oxide of anatase type incorporated therein.

### [Observation of the cross section of TiO₂ layer by a TEM]

The sample electrode was cut and its cross section was observed by a TEM in the same way as in Example 33.

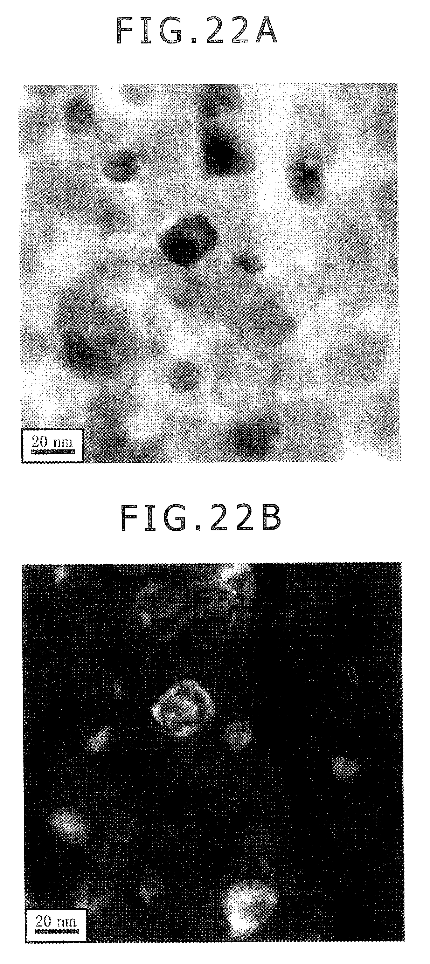

Figs. 22A and 22B are enlarged TEM micrographs showing a portion of the TiO₂ layer. Fig. 22A is a bright-field micrograph showing the cross section of the TiO₂ layer. Fig. 22B is a high-contrast dark-field micrograph showing the orientation of the spherical crystal at the center.

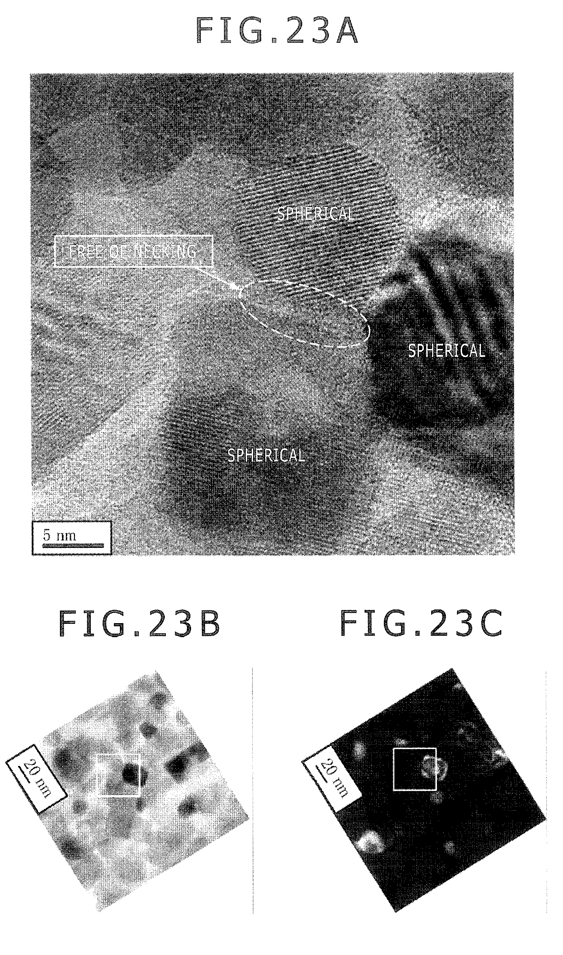

Fig. 23A is an enlarged micrograph showing the portions indicated in Figs. 22A and 22B. The definite regions for enlargement are indicated by frames in Fig. 23B (identical with Fig. 22A) and Fig. 23C (identical with Fig. 22B).

It is noted from Fig. 23A that there is no necking through faces (but there is only necking through points) between the spherical particles of titanium oxide. Therefore, it is considered that there exists no good conduction pass in the TiO₂ layer on account of necking through points between particles.

The dye-sensitized solar cell having the TiO₂ layer incorporated with spindle-shaped particles of peroxo-modified titanium oxide of anatase type has a high fill factor FF and an improved conversion efficiency η as mentioned above. The reason for this is conjectured as follows although it is not known well at the present time.

It has been generally considered that a high performance is achieved if the titanium oxide paste contains titanium oxide particles having an average particle diameter ranging from 5 nm to 30 nm. The reason for this is that such titanium oxide particles have a wide roughness factor and absorb much sensitizing dye, thereby producing many sites for light exciting. Consequently, titanium oxide particles in common use are those having an average particle diameter ranging from 5 nm to 30 nm. Such titanium oxide particles, however, lead to a high resistance on account of their insufficient necking.

Necking between spherical titanium oxide particles starts from the point-to-point contact between spherical particles, but necking in this mode does not proceed sufficiently.

By contrast, in the case of spindle-shaped particles of peroxo-modified titanium oxide of anatase type, necking easily proceeds because they have a flat surface and also have highly reactive peroxo groups on their surface, which promotes contact between titanium oxide particles. The necking that easily proceeds contributes to conductivity between titanium oxide particles and hence the resulting TiO₂ layer has a low resistance.

The present disclosure was described above with reference to the embodiments and examples. However, its scope is not restricted to them, but it may be modified and changed within the scope thereof.

The foregoing embodiments vary in structure, method, process, shape, material, and numerical value but such variation is merely an example and further variation will be possible.

The structure, method, process, shape, material, and numerical value used in the foregoing embodiments will be variously combined within the scope of the present disclosure.

The foregoing embodiments employ the titanium oxide paste and modified titanium oxide paste which contain titanium oxide particles having the crystal structure of anatase type, but the crystal structure of titanium oxide particles is not limited thereto. The titanium oxide particles may include the crystal structure of rutile type or brookite type, for instance.

The foregoing embodiments employ the titanium oxide paste and modified titanium oxide paste which contain crystalline particles of titanium oxide. However, the titanium oxide particles may be amorphous ones. The baking step is intended to convert the titanium oxide into that of anatase type, rutile type, or brookite type. Conversion into the crystal structure of anatase type is particularly desirable.

The second embodiment mentioned above may be modified such that the spindle-shaped particles of peroxo-modified titanium oxide of anatase type (which are dispersed in the paste of modified titanium oxide) are replaced by spherical ones. However, the spindle-shaped particles are desirable from the standpoint of improved conversion efficiency.

The embodiment of the present disclosure provides a process for producing a dye-sensitized solar cell having a small internal resistance and a high photoelectric conversion efficiency.

The present disclosure contains subject matter related to that disclosed in Japanese Priority Patent Applications JP 2010-144379 and JP 2011-010293 filed in the Japan Patent Office on June 25, 2010 and Japan Patent Office on January 20, 2011 respectively, the entire contents of which are hereby incorporated by reference.

It should be understood by those skilled in the art that various modifications, combinations, sub-combinations and alterations may occur depending on design requirements and other factors insofar as they are within the scope of the appended claims or the equivalents thereof.

Thus in accordance with some embodiments of the invention there is provided a photoelectric conversion element comprising an electrode including a titanium oxide layer containing spindle-shaped particles of titanium oxide of anatase type. The photoelectric conversion element may further comprise a counter electrode disposed opposite to the titanium oxide layer, and furthermore may further comprise an electrolyte layer disposed between the titanium oxide layer and the counter electrode.

In accordance with other embodiments of the invention there is provided a method of manufacturing a photoelectric conversion element, the method comprising: providing a transparent conductive layer; and forming a titanium oxide layer containing particles of peroxo-modified titanium oxide of anatase type adjacent to the transparent conductive layer.

In accordance with some embodiments the method may further comprise baking the titanium oxide layer.

In accordance with some embodiments forming the titanium oxide layer may comprise forming a porous titanium oxide layer on the transparent conductive layer.

In accordance with some embodiments the method may further comprise applying a dispersion containing particles of peroxo-modified titanium oxide of anatase type to the porous titanium oxide layer.

In accordance with some embodiments applying the dispersion containing particles of peroxo-modified titanium oxide of anatase type may comprise dipping the porous titanium oxide layer in the dispersion containing particles of peroxo-modified titanium oxide of anatase type.

In accordance with some embodiments the method may further comprise baking the titanium oxide layer.

In accordance with some embodiments the dispersion may contain solids in an amount falling within a range of between about 0.1 wt% and about 3.0 wt% of the dispersion.

In accordance with some embodiments the dispersion may contain solids in an amount falling within a range of between about 0.5 wt% and about 2.5 wt% of the dispersion.

In accordance with some embodiments the dispersion may contain particles of peroxo-modified titanium oxide of anatase type having an average particle diameter falling within a range of between about 3 nm and about 100 nm.

In accordance with some embodiments the dispersion may contain particles of peroxo-modified titanium oxide of anatase type having an average particle diameter falling within a range of between about 3 nm and about 50 nm.

In accordance with some embodiments the dispersion may con-tains particles of peroxo-modified titanium oxide of anatase type having an average particle diameter falling within a range of between about 5 nm and about 60 nm.

In accordance with some embodiments forming the titanium oxide layer may comprise applying a titanium oxide paste con-taining particles of peroxo-modified titanium oxide of anatase type to the transparent conductive layer.

In accordance with some embodiments the method may further comprise baking the titanium oxide layer.

In accordance with some embodiments the titanium oxide paste may contain particles of peroxo-modified titanium oxide of anatase type having an average particle diameter falling within a range of between about 5 nm and about 250 nm.

In accordance with some embodiments the titanium oxide paste may contain particles of peroxo-modified titanium oxide of anatase type having an average particle diameter falling within a range of between about 5 nm and about 100 nm.

In accordance with some embodiments the titanium oxide paste may contain particles of peroxo-modified titanium oxide of anatase type having an average particle diameter falling within a range of between about 5 nm and about 50 nm.

In accordance with some embodiments a plurality of the particles of peroxo-modified titanium oxide of anatase type may be spindle-shaped.

In accordance with some embodiments a plurality of the particles of peroxo-modified titanium oxide of anatase type may be spherical-shaped.

In accordance with some embodiments forming the titanium oxide layer may comprise bonding particles of peroxo-modified titanium oxide of anatase type together to form a matched crys-tal lattice at an interface of the bonded particles.

In accordance with some embodiments the method may further comprise irradiating the titanium oxide layer with UV light or plasma.

## Claims

1. A photoelectric conversion element comprising an electrode including a titanium oxide layer containing spindle-shaped particles of titanium oxide of anatase type.

2. The photoelectric conversion element of claim 1, wherein the spindle-shaped particles of titanium oxide of anatase type are bonded together with other particles of titanium oxide of anatase type to form a matched crystal lattice at an interface of the bonded particles.

3. The photoelectric conversion element of claim 1, wherein an average particle diameter of the spindle-shaped particles of titanium oxide of anatase type falls within a range selected from a group comprising: between about 5 nm and about 250 nm; and between about 10 nm and about 100 nm.

4. The photoelectric conversion element of claim 1, wherein an average long-axis diameter of the spindle-shaped particles of titanium oxide of anatase type falls within a range of between about 30 nm and about 100 nm and / or wherein an average short-axis diameter of the spindle-shaped particles of titanium oxide of anatase type falls within a range of between about 5 nm and about 20 nm.

5. The photoelectric conversion element of claim 1, wherein an average ratio of a long-axis diameter to a short-axis diameter of the spindle-shaped particles of titanium oxide of anatase type has a value selected from a group comprising: greater than 1.5; within a range of between 2 and 20; and within a range of between 3 and 9.

6. The photoelectric conversion element of claim 1, further comprising spherical-shaped particles of titanium oxide of anatase type.

7. The photoelectric conversion element of claim 6, wherein the spherical-shaped particles of titanium oxide of anatase type bond with adjoining spindle-shaped particles of titanium oxide of anatase type to form a matched crystal lattice at an interface of the bonded particles.

8. The photoelectric conversion element of claim 6, wherein an average particle diameter of the spherical-shaped particles of titanium oxide of anatase type falls within a range selected from a group comprising: between about 5 nm and about 250 nm; between about 5 nm and about 100 nm; and between about 5 nm and about 50 nm.

9. The photoelectric conversion element of claim 6, wherein a ratio of spindle-shaped particles of titanium oxide of anatase type to a total sum of spherical-shaped particles of titanium oxide of anatase type and spindle-shaped particles of titanium oxide of anatase type falls within a range of between about 5 wt% and about 30 wt%.

10. The photoelectric conversion element of claim 1, wherein the titanium oxide of anatase type is peroxo-modified titanium oxide of anatase type.

11. The photoelectric conversion element of claim 1, further comprising a counter electrode disposed opposite to the titanium oxide layer.

12. A method of manufacturing a photoelectric conversion element, the method comprising:
providing a transparent conductive layer; and
forming a titanium oxide layer containing particles of peroxo-modified titanium oxide of anatase type adjacent to the transparent conductive layer.

13. The method of claim 12, further comprising baking the titanium oxide layer.

14. The method of claim 12, wherein forming the titanium oxide layer comprises at least one of:
forming a porous titanium oxide layer on the transparent conductive layer;
applying a titanium oxide paste containing particles of peroxo-modified titanium oxide of anatase type to the transparent conductive layer; and
bonding particles of peroxo-modified titanium oxide of anatase type together to form a matched crystal lattice at an interface of the bonded particles.

15. The method of claim 12, further comprising irradiating the titanium oxide layer with UV light or plasma.
